# FASCICULE DE BREVET EUROPEEN

(11) **EP 3 593 376 B1**
(45) Date de publication et mention de la délivrance du brevet: **21.02.2024**
(21) Numéro de dépôt: 18708700.2
(22) Date de dépôt: 07.03.2018
(51) Int. Cl.: H01L 21/60, H01L 21/683, H01L 21/98

(54) **PROCÉDÉ D'AUTO-ASSEMBLAGE DE COMPOSANTS MICROÉLECTRONIQUES**
VERFAHREN ZUR SELBSTASSEMBLIERUNG VON MIKROELEKTRONISCHEN BAUTEILEN
METHOD FOR SELF-ASSEMBLY OF MICROELECTRONIC COMPONENTS

(30) Priorité: 08.03.2017 FR 1751901
(43) Date de publication de la demande: 15.01.2020
(73) Titulaire: Commissariat à l'Energie Atomique et aux Energies Alternatives, 75015 Paris (FR)
(72) Inventeur: DI CIOCCIO, Léa, 38330 Saint Ismier (FR)
(74) Mandataire: Bronchart, Quentin
(86) Numéro de dépôt international: PCT/EP2018/055687
(87) Numéro de publication internationale: WO 2018/162605

(56) Documents cités:
- WO-A1-2012/133760
- FR-A1- 3 039 700
- US-A1- 2007 269 914
- US-A1- 2010 123 268
- US-A1- 2012 021 563
- US-A1- 2012 291 950
- US-A1- 2015 303 082
- Gert-Willem Römer ET AL: "Laser micro-machining of hydrophobic-hydrophilic patterns for fluid driven self-alignment in micro-assembly", , 1 janvier 2011 (2011-01-01), XP055272596, Extrait de l'Internet: URL:http://doc.utwente.nl/79554/1/Romer11l aser.pdf [extrait le 2016-05-13]

## Description

### DOMAINE TECHNIQUE DE L'INVENTION

L'invention concerne le domaine de l'intégration tridimensionnelle de composants microélectroniques. L'invention concerne plus particulièrement un procédé d'auto-assemblage de composants microélectroniques.

Elle trouve pour application particulièrement avantageuse la fabrication industrielle de circuits intégrés en trois dimensions (ou « three-dimensional integrated circuits (3D ICs) » selon la terminologie anglo-saxonne).

En microélectronique, un circuit intégré en trois dimensions est un circuit intégré fabriqué par empilement de tranches (ou plaques) notamment en silicium (ou « wafers » selon la terminologie anglo-saxonne) et/ou de puces (ou « dies » selon la terminologie anglo-saxonne), le cas échéant fonctionnalisées, et en les interconnectant au moins en partie verticalement à l'aide de trous d'interconnexion réalisés à travers une tranche (ou « through-silicon vias (TSVs) » selon la terminologie anglo-saxonne).

### ÉTAT DE LA TECHNIQUE

Dans le cadre de l'intégration 3D des composants microélectroniques, plusieurs approches ont été étudiées dont l'approche dite 'plaque à plaque', l'approche dite 'plaque à plaque séquentielle' et l'approche dite 'puce à plaque'.

Selon l'approche 'plaque à plaque' (ou « Wafer-to-Wafer (W2W) » selon la terminologie anglo-saxonne), des puces sont fabriquées sur deux ou plusieurs plaques à base de matériau semi-conducteur qui sont ensuite alignées, collées entre elles, et coupées en dés pour constituer au moins la base d'autant de circuits intégrés 3D. Cette approche permet d'hybrider de nombreuses puces en une seule fois, mais montre certaines limites. Tout d'abord, elle présente un faible rendement qualitatif, du fait qu'il suffit qu'un composant électronique sur une plaque soit défectueux pour que l'empilement le comprenant soit également défectueux. Ensuite, elle ne permet d'hybrider que des composants microélectroniques de même taille. Par ailleurs, l'alignement obtenu est celui que permettent les équipements d'alignement *ad hoc* (Cf. notamment l'article intitulé « Wafer-to-Wafer Alignment for Three-Dimensional intégration: A Review », de Sag Hwui Lee et al., publié dans la revue « Journal Of Microelectromechanical Systems », Vol. 20, No. 4, août 2011).

Selon l'approche 'plaque à plaque séquentielle', une plaque est fonctionnalisée avant qu'une couche de silicium y soit reportée par collage direct. Cette couche de silicium est ensuite elle-même fonctionnalisée et les deux étages sont alors connectés avec un alignement qui est celui atteignable par la méthode de fonctionnalisation utilisée, à savoir la lithographie, c'est-à-dire un alignement précis à quelques dizaines de nanomètres près. Cependant, cette approche se heurte à la mise en place d'une technologie de fonctionnalisation à basse température pour fonctionnaliser l'étage de transistors supérieur, sans dégrader les transistors de l'étage inférieur (Cf. notamment l'article intitulé « CoolCube™ : A true 3DVLSI Alternative to Scaling », de J.-E. Michallet et al., publié en mars 2015, dans la revue « Resource Library, Technologies Features 1 »).

L'approche 'puce à plaque' (ou « Die-to-Wafer » selon la terminologie anglo-saxonne) vise à utiliser les puces fonctionnelles d'une plaque et à les reporter, après découpe, sur une plaque préalablement fonctionnalisée. Cette approche présente l'avantage de lever le problème de rendement qualitatif, du fait que chaque puce reportée peut être préalablement testée. En outre, cette approche rend possible une intégration hétérogène de composants microélectroniques. L'alignement des puces sur la plaque est généralement obtenu avec des machines robotisées permettant le prélèvement et le positionnement des puces pour leur assemblage mécanique. Plus particulièrement, chaque puce est positionnée individuellement et mécaniquement par un bras robotique sur la plaque fonctionnalisée. Ces machines sont par la suite appelées machines `pick-and-place' (selon la terminologie anglo-saxonne).

Relativement aux approches 'plaque à plaque' et 'plaque à plaque séquentielle', l'approche 'puce à plaque' présente donc un intérêt majeur. Toutefois, il reste de nombreux points bloquants afin de la rendre viable industriellement. Notamment, le temps nécessaire pour assembler les circuits qui devient de plus en plus élevé à mesure que l'on souhaite atteindre un alignement de plus en plus précis.

En effet, en analysant les performances des machines `pick-and-place ', on constate qu'il devient de plus en plus complexe de concilier cadence et précision d'assemblage.
Plus particulièrement, les machines `pick-and-place' actuellement présentes sur le marché autorisent une précision d'alignement d'une valeur comprise entre 0,5 et 2 µm pour les plus performantes. Cependant, cette haute précision d'alignement s'obtient systématiquement au détriment de la cadence d'assemblage. A titre d'exemple, les machines les plus précises présentent au mieux une cadence d'assemblage de l'ordre de 60 puces par heure ce qui n'est pas viable d'un point de vue industriel.
A l'inverse, en relâchant la contrainte sur la précision d'alignement, il existe à l'heure d'aujourd'hui des machines capables d'assembler 100 000 puces par heure avec une précision d'alignement d'une valeur sensiblement égale à 40 µm. Toutefois, une telle précision d'alignement est insuffisante compte tenu des fortes densités d'interconnexion (des millions par cm²) nécessaires aux composants actuels.

L'approche 'puce à plaque' mettant en oeuvre des machines `pick-and-place' ne permet donc pas d'envisager une application industrielle à grande échelle.

Pour pallier ce problème de conciliation entre cadence et précision d'assemblage, des techniques d'auto-assemblage sont apparues. Pour la plupart, elles allient reconnaissance de forme ou affinité de surface dans un milieu liquide ou dans l'air.

Dans ce contexte, le document de brevet FR 2 988 517 A1 divulgue une technique d'auto-assemblage d'une puce sur un support basée sur le confinement d'une goutte d'eau sur une surface hydrophile entourée d'une surface hydrophobe. Par phénomène naturel de minimisation des forces de tension superficielle, la goutte d'eau permet de forcer l'alignement de la puce sur la surface hydrophile, le collage de la puce se faisant par collage direct après évaporation de l'eau. Cependant, pour confiner la goutte d'eau et obtenir un auto-alignement satisfaisant, il est nécessaire de disposer la puce sur un plot ou protubérance, d'une hauteur minimum de 3 µm, préalablement formée sur le support, afin d'obtenir un contraste de mouillabilité suffisant entre surfaces hydrophile et hydrophobe par effet capillaire de canthotaxis. Cette protubérance est problématique car elle est difficilement intégrable notamment sur des plaques processées sur lesquelles des composants auraient été réalisés.

Le document US 2012/021563 divulgue un procédé de fabrication d'un circuit intégré tridimensionnel. Un substrat porteur comprend une face supérieure fonctionnalisée de sorte à présenter des zones hydrophiles (sensiblement de la taille des puces du circuit) et des zones hydrophobes entre les zones hydrophiles. Cette fonctionnalisation permet de réaliser le positionnement d'une goutte d'eau, éventuellement mélangée à de l'acide fluorhydrique, sur chaque zone hydrophile. Une puce est ensuite amenée, par une face préalablement rendue hydrophile, sur chacune des gouttes positionnées. Une évaporation des gouttes est alors réalisée, qui permet d'obtenir le collage de chaque puce sur une zone hydrophile du substrat porteur. Un substrat de support est amené en contact avec la surface libre des puces par une surface d'attachement pour obtenir le report des puces sur le substrat de support suite au retrait du substrat porteur. Pour s'assurer que la force d'adhésion entre chaque puce et le substrat porteur est inférieure à la force d'adhésion entre chaque puce et le substrat de support, il est proposé soit de structurer par des protubérances chaque zone hydrophile de sorte à minimiser la zone de contact entre chaque zone hydrophile et chaque puce, soit de jouer sur une différence de rugosités de surface entre les zones hydrophiles du substrat porteur et la zone d'attachement du substrat de support. Ces solutions sont tout aussi nécessaires que difficiles à mettre en oeuvre de façon maîtrisée.

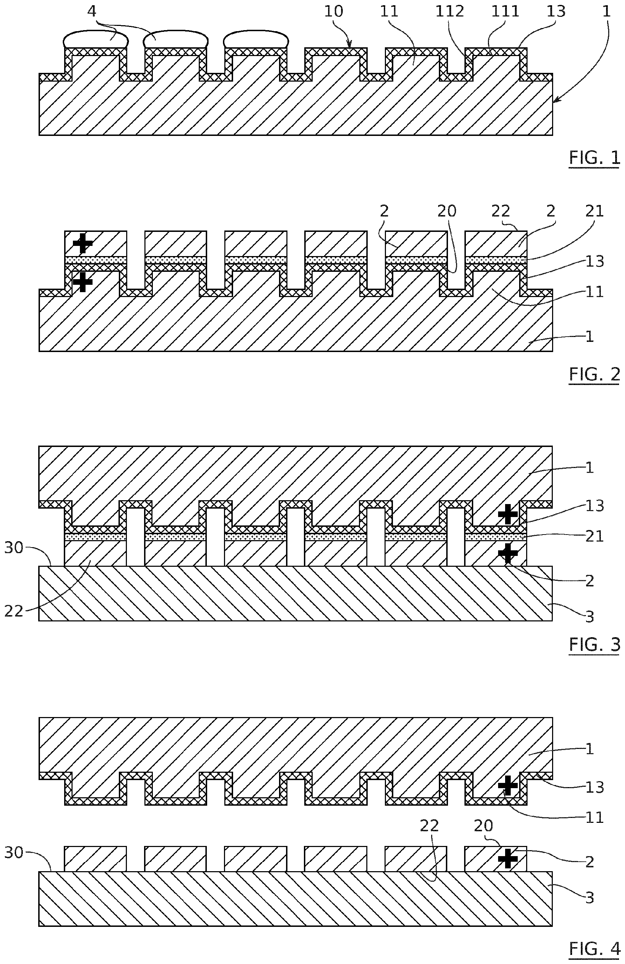

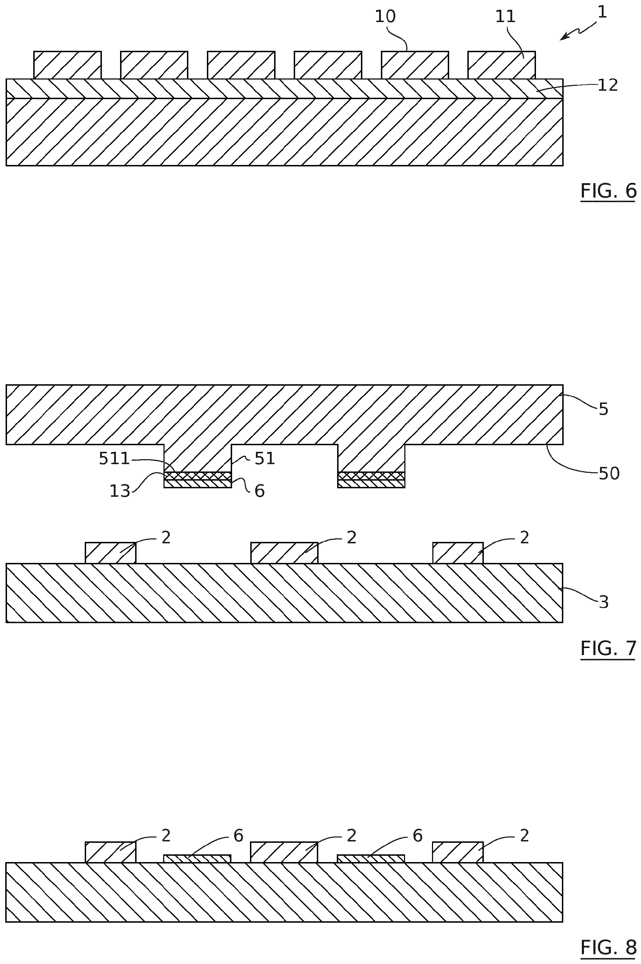

Le document US2012/0291950 A1 divulgue un procédé comprenant une étape d'auto-alignement d'une pluralité de puces sur un premier substrat par effet capillaire (voir figures 3A à 3G), suivie par une étape d'assemblage desdites puces sur un deuxième substrat (voir figures 7A et 7B).

Un objet de la présente invention est de répondre, au moins en partie, aux limitations précédemment exposées.

### RÉSUMÉ DE L'INVENTION

Pour atteindre cet objectif, selon un mode de réalisation, la présente invention prévoit un procédé d'auto-assemblage de composants microélectroniques tel que défini dans la revendication 1 et comprenant les étapes suivantes :
- Fournir un substrat dit d'auto-alignement comprenant une pluralité de protubérances présentant chacune une épaisseur supérieure à 1 µm et présentant chacune une face supérieure et des flancs, la face supérieure et les flancs étant hydrophobes,
- Fournir une pluralité de puces, chaque puce présentant une première face et une deuxième face hydrophile,
- Fournir un substrat dit d'auto-assemblage,
- Obtenir, par effet capillaire, l'auto-alignement de chaque puce, par sa première face, sur une unique protubérance du substrat d'auto-alignement, typiquement selon une approche du type 'puce à plaque', puis
- Obtenir l'assemblage de la pluralité de puces sur le substrat d'auto-assemblage, typiquement selon une approche du type 'plaque à plaque', par collage direct sur le substrat d'auto-assemblage de la deuxième face hydrophile de chaque puce.

Le procédé selon l'invention dissocie avantageusement l'auto-alignement et l'auto-assemblage des puces. L'auto-alignement est réalisé par effet capillaire lors d'une étape antérieure selon une approche du type 'puce à plaque' et l'auto-assemblage est réalisé lors d'une étape ultérieure selon une approche du type 'plaque à plaque'. Le procédé permet l'auto-assemblage de puces sur un substrat ne présentant pas nécessairement de protubérances à sa surface et pallie ainsi le problème lié à l'intégration des protubérances sur un substrat d'auto-assemblage processé. Afin d'obtenir une forte énergie de collage entre la deuxième face de chaque puce et le substrat d'auto-assemblage, l'invention prévoit que la deuxième face de chaque puce, c'est-à-dire la face par laquelle chaque puce est reportée par collage direct sur le substrat d'auto-assemblage, est hydrophile. L'on s'assure ainsi que l'énergie de collage direct entre chaque puce et le substrat d'auto-alignement est inférieure à l'énergie de collage direct entre chaque puce et le substrat d'auto-assemblage. Que la face supérieure de chaque protubérance, mais également ses flancs soient hydrophobes permet d'assurer un confinement satisfaisant de la goutte destinée à être posée sur chaque protubérance.

Selon un mode de réalisation particulièrement avantageux, le substrat d'auto-assemblage présente une pluralité de zones de réception hydrophiles et l'obtention de l'assemblage de la pluralité de puces sur le substrat d'auto-assemblage comprend au moins l'alignement du substrat d'auto-alignement et du substrat d'auto-assemblage, de sorte que chaque puce soit située en vis-à-vis d'une zone de réception hydrophile du substrat d'auto-assemblage et soit reportée par collage direct sur la zone de réception hydrophile située en vis-à-vis.

Le procédé selon cette dernière particularité, permet de mieux s'assurer que l'énergie de collage direct entre chaque puce et le substrat d'auto-alignement est inférieure à l'énergie de collage direct entre chaque puce et le substrat d'auto-assemblage.

Un autre aspect de la présente invention concerne un procédé de fabrication d'au moins un composant microélectronique, tel qu'un circuit intégré en trois dimensions, mettant en oeuvre le procédé d'auto-assemblage tel qu'introduit ci-dessus.

Un autre aspect de la présente invention concerne un composant microélectronique, tel qu'un circuit intégré en trois dimensions, fabriqué selon un procédé de fabrication mettant en oeuvre le procédé d'auto-assemblage tel qu'introduit ci-dessus.

Par composant microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...), ainsi que des dispositifs optiques ou optoélectroniques (MOEMS...).

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les FIGURES 1 à 4 sont des représentations schématiques de différentes étapes d'un procédé d'auto-assemblage selon un mode de réalisation de l'invention.
La FIGURE 5 est un ordinogramme de différentes étapes du procédé d'auto-assemblage selon un mode de réalisation de l'invention.
La FIGURE 6 est une représentation schématique d'un substrat d'auto-alignement selon un mode de réalisation de l'invention.
Les FIGURES 7 et 8 sont des représentations schématiques de différentes étapes d'un procédé selon un mode de réalisation de l'invention.
Les FIGURES 9 et 10 sont des représentations schématiques de deux variantes du procédé selon un mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et films ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :
- Avantageusement pour gagner en précision d'alignement, et notamment pour atteindre une précision d'alignement inférieure au micron, l'au moins une puce pourra présenter une première face en protubérance, c'est-à-dire que la première face sera de dimension réduite par rapport à la taille de la puce, la puce présentant un décroché ou mésa en bordure de sa première face. Ce mésa permet d'améliorer significativement le contraste de mouillabilité entre la première face et les flancs de la puce, permettant une meilleure localisation de la goutte et donc un alignement plus précis ;
- Le substrat d'auto-alignement comportant une face avant structurée par ladite au moins une protubérance, fournir le substrat d'auto-alignement peut comprendre l'étape suivante : traiter la face avant du substrat d'auto-alignement pour rendre hydrophobe, voire superhydrophobe :
   ○ au moins la face supérieure et les flancs de ladite au moins une protubérance, et
   ○ potentiellement toute la face avant du substrat d'auto-alignement.
   Le procédé selon l'invention permet ainsi de s'assurer que l'énergie de collage direct entre chaque puce et la face supérieure de la protubérance correspondante est faible, et notamment plus faible qu'une énergie de collage entre chaque puce et une surface non rendue hydrophobe. Plus particulièrement, traiter la face avant du substrat d'auto-alignement peut comprendre au moins l'une parmi les étapes suivantes :
   ○ ladite au moins une protubérance étant à base de silicium, traiter au moins sa face supérieure et ses flancs avec de l'acide fluorhydrique, en solution aqueuse, par exemple à une concentration de 1 % en acide fluorhydrique, ou sous forme vapeur,
   ○ déposer une couche d'un polymère fluoré, de préférence fluorocarboné, au moins sur la face supérieure et les flancs de ladite au moins une protubérance, par exemple par exposition à un plasma formé à partir d'octafluorobutène, d'héxafluoroéthane, de tétrafluorure de carbone 20 et/ou de trifluorométhane,
   ○ déposer une couche de polydiméthylsiloxane (ou PDMS) au moins sur la face supérieure et les flancs de ladite au moins une protubérance,
   ○ déposer une couche de SiOC au moins sur la face supérieure et les flancs de ladite au moins une protubérance, par exemple par dépôt chimique en phase vapeur (ou CVD pour « Chemical Vapor Déposition » selon la terminologie anglo-saxonne) assisté par plasma en utilisant un gaz comprenant du silicium, un gaz contenant de l'oxygène et un gaz comprenant du carbone,
   ○ le substrat d'auto-alignement étant à base de silicium (Si), graver le substrat d'auto-alignement par plasma de manière à obtenir du silicium noir au moins sur la face supérieure et les flancs de ladite au moins une protubérance, et
   ○ le substrat d'auto-alignement étant à base de silicium (Si), graver le substrat d'auto-alignement par plasma de manière à obtenir du silicium noir et déposer une couche d'un polymère fluoré, de préférence fluorocarboné, au moins sur la face supérieure et les flancs de ladite au moins une protubérance.
      De nombreuses méthodes pour rendre hydrophobe, voire superhydrophobe, une surface sont donc avantageusement envisageables ici ;
- Obtenir l'auto-alignement d'une puce sur une protubérance du substrat d'auto-alignement peut comprendre au moins les étapes successives suivantes :
   ○ déposer une goutte d'un liquide comprenant par exemple de l'eau sur l'une parmi la face supérieure de la protubérance et la première face de la puce, la goutte ayant de préférence un volume compris entre 0,5 et 2 µL, encore plus préférentiellement comprise entre 0,8 et 1,2 µL,
   ○ amener la puce sur la protubérance de sorte à ce que la goutte soit disposée entre la puce et la protubérance et obtenir ainsi l'auto-alignement de la puce sur la protubérance par effet capillaire, et
   ○ faire évaporer la goutte de sorte à obtenir le collage direct de la puce, par sa première face, sur la face supérieure de la protubérance.
      Le procédé selon l'invention permet ainsi d'obtenir un auto-alignement micrométrique pour 90 % des puces sur le substrat d'auto-alignement, soit un auto-alignement à haut rendement à la fois qualitatif et quantitatif ;
- Obtenir l'auto-alignement d'une puce sur une protubérance du substrat d'auto-alignement peut comprendre, lorsqu'une puce est non alignée suite à l'évaporation de la goutte, au moins les étapes successives suivantes :
   ○ éloigner la puce non alignée de la protubérance,
   ○ nettoyer au moins l'une parmi la face supérieure de ladite protubérance depuis laquelle la puce a été éloignée et la première face de la puce, et
   ○ ramener la puce par sa première face sur ladite protubérance de sorte à obtenir l'alignement et le collage de la puce sur ladite protubérance.
   Le procédé selon l'invention permet ainsi de corriger les éventuelles erreurs d'alignement observées pour tendre à atteindre l'alignement de 100 % des puces. Lorsque les puces sont d'ores et déjà majoritairement alignées avec une précision micrométrique, l'utilisation d'une machine `pick-and-place' à haute précision peut être industriellement envisageable pour corriger l'alignement des autres puces ;
- Au moins lorsque plusieurs puces sont d'épaisseurs sensiblement différentes entre elles, fournir le substrat d'auto-alignement peut comprendre au moins l'étape suivante : déposer une couche d'un polymère compressible, par exemple une couche de polydiméthylsiloxane (ou PDMS), au moins sous une des protubérances, de sorte à pouvoir absorber par compression les différences d'épaisseur entre puces, notamment lors de l'obtention de l'assemblage des puces sur le substrat d'auto-assemblage. Cette particularité du procédé selon l'invention illustre le fait qu'il permet de réaliser une hybridation hétérogène en termes d'épaisseurs des puces ;
- ladite au moins une protubérance présente une épaisseur de préférence supérieure à 8 µm. L'épaisseur des protubérances n'a pas réellement de valeur limite supérieure. Toutefois, il peut être préféré que l'épaisseur des protubérances ne dépasse pas 80 µm ;
- Fournir ladite au moins une puce peut comprendre une étape de singularisation de la puce par découpe d'un substrat donneur par exemple par découpe au laser ou à la scie à fil diamanté ou par découpe plasma (ou « plasma dicing » selon la terminologie anglo-saxonne). Dans ce cas, les deux faces de la puce auront la même dimension. La découpe au laser ou à la scie va permettre d'obtenir une précision d'alignement de l'ordre, voire égale, ou supérieure à 3 µm. La découpe plasma permet d'obtenir une précision d'alignement inférieure à 3 µm, voire inférieure à 1 µm. Il est possible également pour obtenir une précision inférieure à 3 µm, voire inférieure à 1 µm, de procéder à une lithographie suivie d'une gravure du substrat donneur pour définir précisément la première face de la puce. Si le substrat donneur est mince, cette étape peut suffire à singulariser la puce. Si le substrat est plus épais, on pourra avoir recours à une étape ultérieure de découpe au laser ou à la scie pour singulariser la puce. Dans ce dernier cas, la deuxième face de la puce sera légèrement en retrait par rapport à la puce. Chaque puce est ainsi avantageusement fournie en définissant parfaitement la première face de la puce par laquelle elle est destinée à être auto-alignée sur une protubérance du substrat d'auto-alignement ;
- En alternative ou en complément à la caractéristique précédente, fournir ladite au moins une puce peut comprendre au moins les étapes successives suivantes :
   ○ Eventuellement définir les flancs de la première face de la puce par gravure d'un substrat donneur sur une profondeur supérieure à 1 µm et inférieure à 100 µm,
   ○ Singulariser ladite au moins une puce en gravant le substrat donneur, de préférence sur une profondeur sensiblement égale à 100 µm, par exemple par photolithographie, et
   ○ Découper ladite au moins une puce depuis le substrat donneur, par exemple par découpe au laser ou à la scie à fil diamanté ;
- Fournir ladite au moins une puce peut comprendre l'étape suivante : traiter la puce de manière à la fonctionnaliser, notamment sur au moins l'une parmi une deuxième face, une première face et une première face amincie de la puce. Cette particularité du procédé selon l'invention illustre le fait qu'il permet de réaliser une hybridation hétérogène en termes de fonctionnalités des puces ;
- Fournir ladite au moins une puce peut en outre comprendre l'étape suivante : préparer la puce de sorte que sa première face soit hydrophobe et présente plus particulièrement un angle de contact supérieur ou égal à 20°, la première face étant celle par laquelle la puce est destinée à être auto-alignée sur une protubérance. Les étapes consistant à fournir ladite au moins une puce et à fournir le substrat d'auto-alignement peuvent être réalisées de sorte que la face supérieure de chaque protubérance et la puce destinée à être auto-alignée sur cette protubérance soient sensiblement de mêmes dimensions ;
- Selon un mode de réalisation, la deuxième face de la puce présente une surface supérieure à la première face de la puce ;
- Selon un mode de réalisation, la puce présente une protubérance par laquelle elle est destinée à être fixée à la protubérance correspondante du substrat d'auto-alignement, cette protubérance de la première face de la puce présentant une surface inférieure à la surface de la deuxième face de la puce ;
- Selon un mode de réalisation, la protubérance de la première face de la puce présente une surface égale ou sensiblement égale à celle de la protubérance correspondante du substrat d'auto-alignement. Cela permet de faciliter l'auto-centrage de la puce sur la protubérance correspondante du substrat d'auto-alignement. Alternativement, la protubérance de la première face de la puce présente une surface inférieure à celle de la protubérance correspondante du substrat d'auto-alignement ;
- Fournir un substrat d'auto-assemblage peut comprendre des étapes technologiques de manière à le fonctionnaliser, ces étapes technologiques comprenant par exemple au moins l'une parmi les étapes suivantes :
   ○ générer une couche d'un matériau diélectrique sur une partie de la face du substrat d'auto-assemblage sur laquelle une ou ladite au moins une puce est destinée à être assemblée, par oxydation de surface et/ou dépôt,
   ○ générer une couche d'un matériau conducteur sur une partie de la face du substrat d'auto-assemblage sur laquelle une puce est destinée à être assemblée, de sorte à former le cas échéant des pistes conductrices d'interconnexions notamment en cuivre, et
   ○ générer des trous d'interconnexion dans une partie au moins de l'épaisseur du substrat d'auto-assemblage, et notamment par la face du substrat d'auto-assemblage sur laquelle une puce est destinée à être assemblée.
   Le substrat d'auto-assemblage peut ainsi être un substrat plus particulièrement destiné à faire *in fine* fonctionnellement partie de composants microélectroniques fabriqués par mise en oeuvre du procédé selon l'invention ;
- Obtenir l'assemblage de ladite au moins une puce sur le substrat d'auto-assemblage comprend au moins les étapes successives suivantes :
   ○ reporter, par une de ses faces, le substrat d'auto-assemblage sur la deuxième face hydrophile de chaque puce, le cas échéant ce report étant réalisé en utilisant un équipement d'alignement dit 'plaque à plaque' avec ou sans repérage,
   ○ coller, par collage direct, le substrat d'auto-assemblage sur la deuxième face hydrophile de chaque puce et recuire l'ensemble, de sorte que l'énergie de collage entre chaque puce et le substrat d'auto-assemblage soit supérieure à l'énergie de collage entre chaque puce et le substrat d'auto-alignement, et
   ○ séparer les substrats d'auto-alignement et d'auto-assemblage entre eux de sorte à décoller chaque puce depuis le substrat d'auto-alignement et obtenir le report de chaque puce sur le substrat d'auto-assemblage.
   Le procédé permet ainsi l'assemblage de nombreuses puces selon une approche du type 'plaque à plaque', notamment sans nécessité la mise en oeuvre d'un substrat de transfert entre un substrat donneur et un substrat receveur ; on notera que le substrat d'auto-alignement pourra facilement être réutilisé, éventuellement après une nouvelle préparation de surface ;
- Le procédé peut comprendre en outre, après avoir obtenu l'assemblage d'au moins une première puce sur le substrat d'auto-assemblage, au moins les étapes suivantes :
   ○ fournir un second substrat d'auto-alignement comprenant au moins une protubérance présentant une face supérieure et de flancs hydrophobes, ladite au moins une protubérance du second substrat d'auto-alignement ayant le cas échéant une épaisseur supérieure à l'épaisseur de ladite au moins une protubérance du substrat d'auto-alignement préalablement fourni,
   ○ fournir au moins une seconde puce présentant une première face et une deuxième face opposées entre elles et ayant une épaisseur significativement différente de l'épaisseur de ladite au moins une puce préalablement fournie, la deuxième face de ladite au moins une seconde puce étant hydrophile,
   ○ obtenir, par effet capillaire, l'auto-alignement de ladite au moins une seconde puce, par sa première face, sur l'au moins une protubérance du second substrat d'auto-alignement, typiquement selon une approche du type 'puce à plaque', puis
   ○ obtenir l'assemblage de ladite au moins une seconde puce sur le substrat d'auto-assemblage, typiquement selon une approche du type 'plaque à plaque', par exemple en un emplacement du substrat d'auto-assemblage différent de l'emplacement de ladite au moins une première puce, par collage direct sur le substrat d'auto-assemblage de la deuxième face de ladite au moins une seconde puce.
   Cette particularité du procédé selon l'invention illustre le fait qu'il permet de réaliser une hybridation hétérogène en termes de tailles variées et d'emplacements d'intégration des puces.

L'usage de l'article indéfini " un " ou " une " pour un élément ou une étape n'exclut pas, sauf mention contraire, la présence d'une pluralité de tels éléments ou étapes.

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais cela signifie que la première couche recouvre au moins partiellement la deuxième couche soit en étant directement à son contact, soit en étant séparée d'elle par au moins une autre couche ou au moins un autre élément.

On entend par « puce » (ou « die » selon la terminologie anglo-saxonne) un morceau, généralement de la forme d'un parallélépipède rectangle, d'une matrice à base d'un matériau semi-conducteur, sur lequel un circuit intégré électronique est destiné à être, ou a été, fabriqué. Les puces sont obtenues par découpe de tranches de la matrice à base de matériau semi-conducteur sur lesquelles sont destinés à être, ou ont été, reproduits, souvent à l'identique, un ou même plusieurs circuits électroniques par une succession de différentes étapes notamment des étapes technologiques telles que des étapes de photolithogravure, d'implants ioniques, de dépôt de couches minces, etc.

On entend par « hybridation (électronique) » l'assemblage de deux composants électroniques, tels que deux puces, en vue d'obtenir une fonction combinée ou un assemblage plus dense.

On entend par « auto-assemblage » la qualité d'une technique d'assemblage dans laquelle, lorsqu'on place des éléments à assembler dans des conditions particulières, ces éléments s'assemblent spontanément pour former une structure.

On entend par « auto-alignement » l'action par laquelle, lorsqu'on place des éléments à aligner dans des conditions particulières, ces éléments s'alignent spontanément.

On entend par « hydrophobe » la propriété d'une surface d'un matériau solide sur laquelle une goutte d'eau forme, lorsqu'elle est en équilibre avec l'air ambiant, un angle de contact supérieur ou égal à 20°, de préférence supérieur à 60°, encore plus préférentiellement supérieur à 65°.

On entend par « superhydrophobe » la propriété physique, telle qu'une structuration, d'une surface d'un matériau solide sur laquelle une goutte d'eau forme, lorsqu'elle est en équilibre avec l'air ambiant, un angle de contact supérieur ou égal à 150°.

On entend par « hydrophile » la propriété d'une surface d'un matériau solide sur laquelle une goutte d'eau forme, lorsqu'elle est en équilibre avec l'air ambiant, un angle de contact inférieur à 10°, de préférence inférieur à 5°, et encore plus préférentiellement sensiblement égal à 2°.

Dans la description qui suit, les épaisseurs de substrat, de film, de couche, de puce ou de protubérance sont généralement mesurées selon une direction perpendiculaire au plan d'extension principale du substrat, du film, de la couche, de la puce ou de la protubérance.

On entend par un substrat, un film, une couche, une puce ou une protubérance « à base » d'un matériau A, un substrat, un film, une couche, une puce ou une protubérance comprenant ce matériau A et éventuellement d'autres matériaux, par exemple des éléments dopants.

Le terme « revêtement » correspond à une couche qui est formée, en particulier par modification de la couche sous-jacente ou par un dépôt sur cette couche sous-jacente.

Le mot « diélectrique » qualifie un matériau dont la conductivité électrique est suffisamment faible dans l'application donnée pour servir d'isolant.

On entend par « collage direct » un collage sans apport de matière adhésive (de type colle ou polymère notamment) qui consiste en la mise en contact de surfaces relativement lisses (d'une rugosité typiquement inférieure à 5 Å), par exemple réalisé à température ambiante et sous atmosphère ambiant, afin de créer une adhérence entre elles.

Selon un mode de réalisation, le collage direct de deux composants signifie que le collage est obtenu par les liens chimiques qui s'établissent entre les deux surfaces mises en contact. Les deux surfaces présentent des rugosités suffisamment faibles pour que les forces de Van der Waals assurent, de préférence à elles seules, un maintien des deux composants entre eux.

Le collage direct est en outre obtenu sans nécessiter l'application d'une pression importante sur la structure à assembler. Une légère pression pourra simplement être appliquée pour initier le collage.

Le collage direct implique ou non une couche intermédiaire de collage (par exemple une couche d'oxyde de silicium). Ainsi, l'interface de collage entre deux substrats peut comprendre une couche intermédiaire.

Chaque surface destinée à être reportée par collage direct peut être préparée pour un collage direct de qualité. Le niveau de rugosité requis pourra être obtenu par un dépôt adapté ou après une étape de polissage mécano-chimique. En fonction de la surface, on utilisera un nettoyage type SC1 et SC2, un plasma O₂ ou UV/ozone (surface avec oxyde), une préparation He/H pour des surfaces cuivre ou cuivre/oxyde, avec éventuellement un nettoyage par rouleau-brosse dit 'scrubber', ainsi qu'un séchage.

On entend par « énergie de collage » entre deux éléments l'énergie nécessaire pour réaliser la séparation de ces deux éléments.

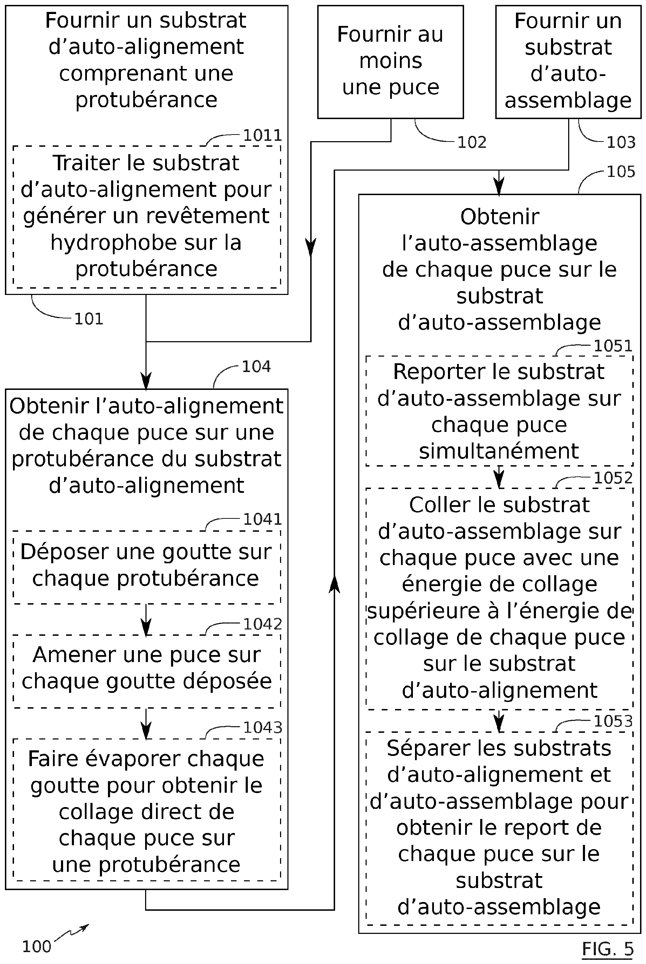

En référence à la figure 5, le procédé d'auto-assemblage 100 de composants microélectroniques comprend au moins les étapes suivantes:
- Fournir 101 un substrat dit d'auto-alignement 1 comprenant au moins une protubérance 11,
- Fournir 102 au moins une puce 2,
- Fournir 103 un substrat dit d'auto-assemblage 3,
- Obtenir 104 l'auto-alignement de chaque 2 sur une protubérance 11 correspondante du substrat d'auto-alignement 1, puis
- Obtenir 105 l'assemblage de chaque puce 2 sur le substrat d'auto-assemblage 3.

Le procédé 100 selon l'invention vise à être mis en oeuvre de façon industrielle. Dans cette perspective, il peut être préféré de fournir 101 un substrat d'auto-alignement 1 comprenant une face avant 10 structurée par une pluralité de protubérances 11 et de fournir 102 une pluralité de puces 2, chaque puce 2 étant destinée à être auto-alignée sur une protubérance 11 correspondante.

Selon certaines caractéristiques du procédé 100 :
- les protubérances 11 présentent une face supérieure 111 et des flancs 112, la face supérieure et les flancs étant hydrophobes, voire superhydrophobes, ou munis d'un revêtement 13 hydrophobe, voire superhydrophobe, et
- l'obtention 104 de l'auto-alignement de chaque puce 2 sur une protubérance 11 est obtenue par effet capillaire, c'est-à-dire sous l'effet des forces de rappel d'une goutte interposée entre la puce 2 et la protubérance 11, et
- l'obtention 105 de l'assemblage des puces 2 sur le substrat d'auto-assemblage 31 est réalisée par collage direct.

Il n'est pas exclu que le substrat d'auto-alignement 1 et ses protubérances 11 soient à base d'un matériau hydrophobe.

Notamment en référence à la figure 1, on forme une pluralité de protubérances 11 à la surface d'un substrat initial. Par exemple, les protubérances peuvent être formées par photolithographie, autrement dit par une méthode de gravure industrielle parfaitement maitrisée et permettant l'obtention de substrats d'auto-alignement 1 à la fois variés et spécifiques en termes d'emplacements et de dimensionnements des protubérances 11. Cette méthode permet également de définir avec précision la forme, l'épaisseur et les dimensions transversales des protubérances 11. Toutefois, l'invention n'est pas limitée à cette méthode de formation des protubérances 11. En effet, selon un autre exemple, les protubérances 11 peuvent être formées individuellement, par exemple par découpe d'un substrat de base, puis reportées sur le substrat initial qui forme alors la base du substrat d'auto-alignement 1 ; ce report comprend alors le collage des protubérances 11, par exemple par collage polymérique sur une face avant du substrat initial. Ce collage doit présenter une énergie supérieure à l'énergie de collage qui sera obtenue entre la puce 2 et la protubérance 11 si on souhaite pouvoir séparer ultérieurement la puce 2 et la protubérance 11 au niveau de leur interface de collage. L'intérêt de cette technique est de permettre d'interposer, entre le substrat initial et les protubérances 11, une couche tampon souple, par exemple à base d'un polymère compressible, qui pourrait absorber lors du collage ultérieur des différences de hauteurs entre certaines protubérances et/ou certaines puces 2.

En référence à la figure 1, les protubérances 11 présentent de préférence sensiblement la forme d'un parallélépipède. Plus particulièrement, chaque protubérance 11 présente des flancs 112 et une face supérieure 111 de préférence sensiblement plane. De préférence, chaque protubérance est formée de sorte que sa face supérieure 111 soit sensiblement de mêmes dimensions que la puce 2 destinée à être auto-alignée sur cette protubérance 11. Notamment afin de bénéficier de l'effet capillaire de canthotaxis, sur lequel nous reviendrons plus bas, chaque protubérance 11 présente une épaisseur supérieure à 1 µm, de préférence comprise entre 8 µm et 80 µm.

Que non seulement la face supérieure 111, mais également les flancs 112, de chaque protubérance 11 soient hydrophobes permet de s'assurer d'un confinement satisfaisant de la goutte 4 destinée à être posée sur la face supérieure 111 de la protubérance 11. En ce sens, que l'épaisseur de chaque protubérance soit supérieure à 1 µm a également son importance. En outre, utiliser une protubérance hydrophobe permet d'obtenir un bien meilleur alignement qu'avec une surface hydrophile, ainsi qu'un collage faible en énergie, collage qui reste faible même après un traitement thermique, par exemple jusque 400°C, et qui se démonte facilement.

Si le substrat d'auto-alignement 1 et/ou les protubérances 11 ne sont pas hydrophobes par nature, on peut traiter 1011 le substrat d'auto-alignement au niveau de sa face avant 10 pour la rendre hydrophobe, voire superhydrophobe, et/ou générer un revêtement 13 hydrophobe, voire superhydrophobe, au moins au niveau des faces supérieures 111 et des flancs 112 des protubérances 11. Comme illustré sur la figure 1, toute la face avant 10 du substrat d'auto-alignement 1 peut être (rendue) (super)hydrophobe. Le procédé 100 selon cette particularité permet de s'assurer que l'énergie de collage direct entre chaque puce 2 et la face supérieure 111 de la protubérance 11 correspondante est faible, notamment plus faible qu'une énergie de collage entre chaque puce 2 et une surface non (rendue) hydrophobe, et en particulier bien plus faible qu'une énergie de fracture du substrat d'auto-alignement 1. En outre, lorsque l'auto-alignement des puces 2 sur le substrat d'auto-alignement 1 est obtenu par effet capillaire, comme cela sera décrit en détails plus bas, la (super)hydrophobie de la face supérieure 111 des protubérances 11 permet d'atteindre un auto-alignement micrométrique pour environ 90 % des puces 2, soit un auto-alignement à haut rendement à la fois qualitatif et quantitatif.

De nombreuses méthodes de génération d'une (super)hydrophobie sont envisageables qui permettent d'atteindre autant de niveau d'hydrophobie ou de superhydrophobie pour une adaptabilité au cas par cas du procédé selon l'invention. Parmi ces méthodes, l'on peut citer celles comprenant l'une au moins des étapes suivantes :
- lorsque la protubérance est en silicium, traiter au moins la face supérieure 111 et les flancs 112 de cette protubérance 11 avec de l'acide fluorhydrique, soit en solution aqueuse, par exemple à une concentration de 1 % en acide fluorhydrique soit sous forme vapeur,
- déposer une couche d'un polymère fluoré, de préférence fluorocarboné, au moins sur la face supérieure 111 et les flancs 112 de la protubérance 11, par exemple par exposition à un plasma formé à partir d'octafluorobutène, d'héxafluoroéthane, de tétrafluorure de carbone 20 et/ou de trifluorométhane,
- déposer une couche de polydiméthylsiloxane (ou PDMS), au moins sur la face supérieure 111 et les flancs 112 de la protubérance 11,
- déposer une couche de SiOC au moins sur la face supérieure 111 et les flancs de la protubérance 11, par exemple par dépôt chimique en phase vapeur (ou CVD) assisté par plasma en utilisant un gaz comprenant du silicium, un gaz contenant de l'oxygène et un gaz comprenant du carbone,
- lorsque le substrat d'auto-alignement 1 est à base de silicium Si, graver le substrat d'auto-alignement 1 par plasma de manière à obtenir du silicium noir au moins sur la face supérieure 111 et les flancs 112 de la protubérance 11, et éventuellement déposer ensuite une couche d'un polymère fluoré, de préférence fluorocarboné au moins sur la face supérieure 111 de la protubérance 11.

Nous allons maintenant décrire plus en détail l'étape 102 de fourniture d'au moins une puce 2.

Comme indiqué plus haut, une puce 2 s'entend ici d'un morceau, généralement de la forme d'un parallélépipède rectangle, d'une matrice à base d'un matériau semi-conducteur, tel que le silicium, ou d'un empilement de couches sur lequel un circuit intégré électronique est destiné à être, ou a été, fabriqué. Plus particulièrement, chaque puce 2 présente une première face 20 et une deuxième face 22 de préférence sensiblement planes ; ses dimensions transversales, allant par exemple de quelques millimètres et à quelques dizaines de millimètres, sont supérieures, d'au moins un ordre de grandeur, à son épaisseur de sorte que chaque puce 2 présente un facteur de forme significatif lui conférant notamment une capacité d'auto-alignement par effet capillaire comme cela est décrit dans l'article de J. Berthier et al., intitulé « Self-alignment of silicon chips on wafers : A capillary approach », publié dans « Journal of Applied Physics » de 2010, vol. 108. Chaque puce 2 peut être formée de sorte que sa première face 20, souvent identique à sa deuxième face 22, soit sensiblement de mêmes dimensions que la face supérieure 111 de la protubérance 11 sur laquelle elle est destinée à être auto-alignée. Avantageusement, la première face 20 sera en protubérance de sorte à améliorer l'alignement obtenue par auto-assemblage.

En outre, les puces 2 peuvent être traitées de manière à être fonctionnalisées. Cette fonctionnalisation peut être réalisée sur au moins l'une parmi la deuxième face 22 et la première face 20 de chaque puce 2. Ainsi, il apparaît que le procédé d'auto-assemblage selon l'invention peut permettre de réaliser une hybridation hétérogène en termes de fonctionnalités des puces 2.

Par ailleurs, en référence aux figures 2 et 3, la fourniture 102 des puces 2 peut comprendre au moins l'étape suivante : préparation de la première face 20 de chaque puce 2 pour générer une surface hydrophobe ou peu hydrophile et présentant plus particulièrement un angle de contact supérieur ou égal à 20°. Même si cela améliore encore l'alignement, il n'est pas nécessaire que la première face de chaque puce 2 soit (rendue) hydrophobe. En effet, le fait que la surface de la protubérance 11 soit hydrophobe suffit à obtenir un collage de mauvaise qualité facilement démontable.

Au contraire, on préparera avantageusement la deuxième face 22 pour la rendre hydrophile afin d'obtenir une forte énergie de collage entre cette deuxième face 22 et le substrat d'auto-assemblage 3, notamment après recuit (typiquement comprise entre 1 et 4 J/m²). L'énergie de collage obtenue entre la deuxième face 22 de chaque puce 2 et le substrat d'auto-assemblage 3doit notamment être supérieure à l'énergie de collage entre la première face 20 de chaque puce 2 et le substrat d'auto-alignement 1. La préparation de surface de la deuxième face 22 de chaque puce 2 pourra comprendre le dépôt d'un revêtement de surface adapté, par exemple le dépôt d'une couche d'oxyde. En variante ou en complément, la préparation de surface de la deuxième face 22 de chaque puce 2 pourra alors comprendre une oxydation de surface. On pourra également moduler l'énergie de collage en jouant sur la rugosité des surfaces à coller.

Cette puce pourra être amincie si besoin à différents moments, et notamment avant alignement sur le substrat d'auto-alignement 1 ou après assemblage sur le substrat d'auto-alignement 1 si l'énergie d'assemblage le permet ou encore après report sur le substrat d'auto-assemblage 3.

Nous décrivons ci-après, en référence aux figures 1, 2 et 5, comment obtenir 104, par effet capillaire, l'auto-alignement des puces 2 sur les protubérances 11 du substrat d'auto-alignement 1 selon un mode de réalisation de l'invention.

Pour ce faire, l'étape 104 comprend au moins les étapes successives suivantes :
- Déposer 1041 une goutte 4 d'un liquide sur la face supérieure 111 de la protubérance 11, comme cela est représenté schématiquement sur trois protubérances du substrat d'auto-alignement 1 illustré sur la figure 1, ou sur la première face de la puce,
- Amener 1042 chaque puce 2 sur une protubérance 11 correspondante du substrat d'auto-alignement 1, de sorte à ce que la goutte 4 soit disposée entre la puce 2 et la protubérance 11 et obtenir ainsi l'auto-alignement de la puce 2 sur la protubérance 11, et
- Faire évaporer 1043 la goutte 4, de sorte à obtenir le collage direct de chaque puce 2, par sa première face 20, sur la face supérieure 111 de la protubérance, comme cela est représenté schématiquement sur la figure 2.

Comme décrit précédemment, la face supérieure 111 et les flancs 112 de chaque protubérance 11 peuvent avoir été rendus hydrophobes préalablement au dépôt 1041 de la goutte 4, et ce notamment afin d'assurer un bon confinement de la goutte 4 sur la protubérance 11. Egalement, comme décrit précédemment, la première face 20 de chaque puce 2 peut avoir été rendue hydrophobe préalablement à son amenée 1042 sur la protubérance 11 correspondante, notamment pour obtenir un meilleur alignement de la puce 2 sur la protubérance 11.

Le liquide de chaque goutte 4 peut comprendre de l'eau, le cas échéant mélangée à de l'acide fluorhydrique, ce dernier restant en faible concentration (typiquement inférieure au pourcent). L'eau s'impose ici comme principal constituant du liquide de chaque goutte 4, du fait qu'elle est d'usage courant, mais d'autres liquides de préférence à forte tension de surface pourraient également être utilisés.

Chaque goutte 4 a de préférence un volume compris entre 0,5 et 2 µL, encore plus préférentiellement comprise entre 0,8 et 1,2 µL. En dessous de ces valeurs de volume, le dépôt de la puce 2 sur la protubérance 11 risque de résulter en un contact direct entre la puce 2 et la protubérance 11, ce contact direct étant de fait un point d'accroche susceptible de gêner l'alignement de la puce 2 sur la protubérance 11. Au-dessus de ces valeurs de volume, la goutte 4 pourrait ne plus être confinée sur la protubérance 11 et déborder, mais surtout le temps d'évaporation de la goutte 4 deviendrait important, notamment dans la perspective d'une mise en oeuvre industrielle du procédé selon l'invention. Il est à noter que le volume de la goutte 4 dépend proportionnellement de la surface de la face supérieure 111 de la protubérance 11. Les gammes de valeurs susmentionnées sont particulièrement adaptées à une face supérieure 111 d'une surface de 0,5 cm × 0,5 cm à 1 cm × 1 cm.

La goutte 4 est telle, et est déposée de telle façon, qu'elle forme de préférence un angle de contact supérieur à 60°, de préférence supérieur à 65°, avec la face supérieure 111 de la protubérance 11, dans des conditions normales de température et de pression. Lorsque la première face 20 de la puce 2 est en protubérance, on obtient ainsi un contraste de mouillabilité de l'ordre de 150°, le mésa en bordure de face introduisant un angle supplémentaire de 90° garantissant l'auto-alignement précis des puces 2. Qu'un revêtement 13 hydrophobe, voire superhydrophobe, soit généré sur la face supérieure 111 de chaque protubérance 11 permet certes d'augmenter avantageusement la valeur de cet angle de contact, mais permet surtout de réduire l'énergie de collage direct entre chaque puce 2 et la face supérieure 111 de chaque protubérance.

L'amenée 1042 de chaque puce 2 sur la protubérance 11 correspondante peut être réalisée par mise en oeuvre d'une machine `pick-and-place' avec une précision d'alignement d'une valeur supérieure à 10 µm, de préférence supérieure à 20 µm. En effet, dans la perspective de l'industrialisation du procédé selon l'invention, il est avantageusement envisageable d'utiliser une machine `pick-and-place' à faible précision et à grande cadence pour réaliser cette étape d'amenée 1042. La précision micrométrique de l'alignement de chaque puce 2 est obtenue par effet capillaire de façon liée au phénomène naturel de minimisation des forces de tension superficielle, de sorte que l'utilisation de la machine 'pick-and-place' puisse consister uniquement à amener chaque puce dans une position approximative propre à permettre l'observation subséquente de ce phénomène.

Le collage direct de la puce 2 auto-alignée sur la protubérance 11 est obtenue spontanément une fois la goutte 4 évaporée.

L'étape consistant à faire évaporer 1043 la goutte 4 est avantageusement réalisée par évaporation naturelle.

Le procédé 100 selon l'invention permet ainsi d'obtenir l'auto-alignement micrométrique d'environ 90 % des puces 2 sur le substrat d'auto-alignement 1, soit un auto-alignement à haut rendement à la fois qualitatif et quantitatif.

En outre, le procédé 100 selon l'invention permet encore de corriger les éventuelles erreurs d'alignement observées pour tendre à atteindre l'alignement de 100 % des puces 2. En effet, selon le procédé de l'invention, obtenir 104 l'auto-alignement de chaque puce 2 sur la protubérance 11 correspondante peut comprendre, lorsqu'une puce 2 est non alignée suite à l'évaporation 1043 de la goutte 4, au moins les étapes successives suivantes :
- éloigner, voire décoller, la puce 2 non alignée,
- nettoyer la face supérieure 111 de la protubérance 11 depuis laquelle la puce 2 a été éloignée, voire décollée, et
- ramener, voire recoller, la puce 2, par sa première face 20, sur la protubérance 11 dont la face supérieure 111 a été nettoyée, de sorte à obtenir l'alignement de la puce 2 sur la protubérance 11.

Le décollement de la puce 2 non alignée est d'autant plus aisé que l'énergie de collage direct entre la puce 2 et la protubérance 11 est rendue faible par le revêtement 13 hydrophobe.

Le nettoyage de la face supérieure d'une protubérance 11 est d'autant plus aisé que la protubérance est déjà singularisée sur le substrat d'auto-alignement 1 du fait de sa projection en épaisseur par rapport au reste de la face avant 10 du substrat d'auto-alignement 1.

Lorsque les puces 2 sont d'ores et déjà majoritairement alignées avec une précision micrométrique, par exemple en utilisant une méthode d'auto-alignement par effet capillaire, l'utilisation d'une machine `pick-and-place' à haute précision peut être industriellement envisageable pour corriger l'alignement des autres puces 2, et notamment pour recoller la puce 2 sur la protubérance 11.

Nous décrivons ci-après, en référence aux figures 3, 4 et 5, comment obtenir 105 l'assemblage des puces 2 sur le substrat d'auto-assemblage 3 selon un mode de réalisation de l'invention.

Pour ce faire, l'étape 105 comprend au moins les étapes successives suivantes :
- Reporter 1051, par une 30 de ses faces, le substrat d'auto-assemblage 3 sur une deuxième face 22 de chaque puce 2,
- Coller 1052, par collage direct, de préférence hydrophile, le substrat d'auto-assemblage 3 sur la deuxième face 22 de chaque puce 2 et recuire l'ensemble, de sorte que l'énergie de collage entre chaque puce 2 et le substrat d'auto-assemblage 3 soit supérieure à l'énergie de collage entre chaque puce 2 et le substrat d'auto-alignement 1, et
- Séparer 1053 les substrats d'auto-alignement 1 et d'auto-assemblage 2 entre eux de sorte à décoller les puces 2 depuis le substrat d'auto-alignement 1 et obtenir le report des puces 2 sur le substrat d'auto-assemblage 3.

Le substrat d'auto-assemblage 3 peut présenter une pluralité de zones de réception hydrophiles. Dans ce cas, obtenir 105 l'assemblage de la pluralité de puces 2 sur le substrat d'auto-assemblage 3 comprend au moins l'alignement du substrat d'auto-alignement 1 et du substrat d'auto-assemblage 3, de sorte que chaque puce 2 soit située en vis-à-vis d'une zone de réception hydrophile du substrat d'auto-assemblage 3 et soit reportée par collage direct sur la zone de réception hydrophile située en vis-à-vis. La puce 2 ayant une deuxième face 22 hydrophile, cette face se trouve donc coller à une zone de réception du substrat d'auto-assemblage 3 qui est elle aussi hydrophile ; un collage direct hydrophile est ainsi obtenu entre la deuxième face 22 de chaque puce 2 et le substrat d'auto-assemblage 3. Le recuit déjà évoqué plus haut permet alors de renforcer encore l'énergie de collage entre la deuxième face 22 hydrophile de chaque puce 2 et la zone de réception hydrophile correspondante du substrat d'auto-assemblage 3. Ce recuit peut plus particulièrement consister en un traitement thermique à une température comprise entre 200 et 400°C. Ce traitement permet de renforcer encore le collage hydrophile entre chaque puce 2 et le substrat d'auto-assemblage 3 au détriment du collage hydrophobe entre chaque puce 2 et le substrat d'auto-alignement 1 qui reste lui de même énergie, voire se dégrade, pendant le recuit avec la maturation des défauts de collage en température, ces défauts pouvant même conduire directement à la séparation du substrat d'auto-alignement 1 et des premières faces 21 des puces 2. Ce mécanisme de séparation peut encore être facilité par le choix de matériaux présentant des coefficients de dilatation thermique différents entre le substrat d'auto-assemblage 3 et le substrat d'auto-alignement 1.

Le report 1051 du substrat d'auto-assemblage 3 sur les faces avant 22 des puces 2 peut être est réalisé en utilisant un équipement d'alignement dit plaque à plaque, avec ou sans repérage. Des repères sont représentés sur les figures 3 et 4 par des croix.

Comme illustré sur les figures 2 à 4, les faces avant 22 des puces 2 auto-alignées sont de préférence comprises dans un même plan, de sorte à permettre à une face 30 sensiblement plane du substrat d'auto-assemblage 3 de venir contacter les faces avant 22 des puces 2 auto-alignées en leur entier et de façon simultanée. Toutefois, comme discuté plus bas, le procédé 100 selon l'invention n'est pas limité à cette préférence.

Le procédé 100 selon l'invention permet ainsi l'assemblage de nombreuses puces 2 selon une approche du type 'plaque à plaque', notamment sans nécessité la mise en oeuvre d'un substrat de transfert entre un substrat donneur et un substrat receveur.

En outre, le substrat d'auto-assemblage 3 peut être fonctionnalisé, notamment préalablement à son report 1051, de sorte à assurer des fonctions notamment d'interconnexions entre puces de composants microélectroniques 2D ou 3D.

En effet, la fourniture 103 du substrat d'auto-assemblage 3 peut comprendre des étapes technologiques de manière à fonctionnaliser le substrat d'auto-assemblage 3. Ces étapes technologiques peuvent comprendre par exemple au moins l'une parmi les étapes suivantes :
- générer une couche d'un matériau diélectrique sur une partie d'une face 30 du substrat d'auto-assemblage 3 sur laquelle les puces 2 sont destinées à être assemblées,
- générer une couche d'un matériau conducteur sur une partie d'une face 30 du substrat d'auto-assemblage 3 sur laquelle les puces 2 sont destinées à être assemblées, et
- générer des trous d'interconnexion dans une partie au moins de l'épaisseur du substrat d'auto-assemblage 3, et notamment par la face 30 du substrat d'auto-assemblage 3 sur laquelle les puces 2 sont destinées à être assemblées.

La génération de la couche de matériau diélectrique peut comprendre une oxydation de surface, notamment lorsque le substrat d'auto-assemblage 3 est à base de silicium, ou un dépôt, par exemple d'un oxyde à base du matériau semi-conducteur constituant le substrat d'auto-assemblage 3.

La couche de matériau diélectrique et la couche de matériau conducteur peuvent être générées de sorte à former des pistes conductrices d'interconnexions notamment en cuivre, comme cela est décrit notamment dans l'article de S. Mermoz, intitulé « High density chip-to-wafer intégration using self-assembly : on the performances of directly interconnected structures made by direct copper/oxyde bonding », publié dans le cadre de la conférence « Electronics Packaging Technology » de 2013.

Le procédé 100 selon l'invention permet ainsi l'interconnexion des puces 2 entre elles par leur seul assemblage. Le substrat d'auto-assemblage 3 pouvant en outre comprendre lui-même un ou plusieurs étages de puces 2, et notamment de transistors, le procédé 100 selon l'invention permet la fabrication d'un ou plusieurs étages supplémentaires de composants microélectroniques sans affecter l'intégrité des composants microélectroniques des étages sous-jacents, notamment du fait que le procédé 100 selon l'invention n'implique potentiellement aucun traitement thermique à haute température et/ou aucune immersion dans des environnements potentiellement néfastes.

Au vu des figures 7 et 8, il apparaît que le procédé 100 selon l'invention permet de réaliser une hybridation hétérogène, non seulement en termes d'empilements et de fonctionnalités des puces 2 comme cela a déjà été discuté plus haut, mais également en termes de tailles variées et d'emplacements d'intégration des puces 2 sur le substrat d'auto-assemblage 3.

En effet, en référence aux figures 7 et 8, le procédé 100 selon l'invention peut en outre comprendre une certaine répétition d'étapes pouvant mener à ce type d'intégration complexe. Plus particulièrement, le procédé 100 selon l'invention peut comprendre en outre après avoir obtenu 105 l'auto-assemblage d'une première pluralité de puces 2 sur le substrat d'auto-assemblage 3, au moins les étapes suivantes :
- Fournir un second substrat d'auto-alignement 5 comprenant une pluralité de protubérances 51 présentant une face supérieure 511 munie d'un revêtement 13 au moins hydrophobe,
- Fournir une seconde pluralité de puces 6,
- Obtenir 104, par effet capillaire, et typiquement selon une approche du type 'puce à plaque', l'auto-alignement de chaque puce 6 de la seconde pluralité de puces 6 sur une protubérance 51 correspondante du second substrat d'auto-alignement 5, puis
- Obtenir 105, par collage direct, et typiquement selon une approche du type 'plaque à plaque', l'assemblage de la seconde pluralité de puces 6 sur le substrat d'auto-assemblage 3.

Chaque protubérance 51 a le cas échéant une épaisseur supérieure à l'épaisseur de chaque protubérance 11 structurant la face avant 10 du substrat d'auto-alignement 1 préalablement fourni 101. Cela permet de coller les puces 6 de la seconde pluralité en un emplacement du substrat d'auto-assemblage 3 différent de l'emplacement des puces 2 de la première pluralité, sans contacter les puces 2 déjà assemblées sur le substrat d'auto-assemblage 3.

Les puces 6 de la seconde pluralité ont potentiellement une épaisseur significativement différente de l'épaisseur des puces 2 de la première pluralité. Du fait qu'il est préférable que les faces avant des puces 2, 6 auto-alignées soient sensiblement comprises dans un même plan, de sorte à permettre à une face 30 sensiblement plane du substrat d'auto-assemblage 3 de venir contacter les faces avant des puces 2, 6 auto-alignées en leur entier et de façon simultanée, l'on comprend que l'intégration de puces 2, 6 présentant des épaisseurs significativement différentes entre elles via l'utilisation d'un même substrat d'auto-alignement induit la nécessité de former, sur ce substrat d'auto-alignement, des protubérances d'épaisseurs différentes propres à absorber les différences d'épaisseurs entre puces 2, 6, ce qui compliquerait la fourniture 101 du substrat d'auto-alignement. Le procédé selon cette dernière particularité permet donc de simplifier l'assemblage de puces 2, 6 d'épaisseurs significativement différentes entre elles en prévoyant la fourniture d'une pluralité de substrats d'auto-alignement dont chaque substrat est propre à une classe de puces d'épaisseurs sensiblement identiques entre elles et/ou à un rang d'intégration de puces.

Quelle que soit la méthode utilisée pour former les protubérances 11, il peut être préférable, voire nécessaire, au moins lorsque plusieurs puces 2 sont d'épaisseurs sensiblement différentes entre elles, que la fourniture 101 du substrat d'auto-alignement 1 comprenne en outre au moins l'étape suivante : déposer une couche 12 à base d'un polymère compressible, par exemple une couche de polydiméthylsiloxane (ou PDMS), sous les protubérances 11. Un substrat d'auto-alignement 1 selon cette première variante est illustré sur la figure 6. La couche 12 permet avantageusement d'absorber par compression les légères différences d'épaisseur entre puces 2, notamment pour obtenir 105 l'auto-assemblage des puces 2 sur un substrat d'auto-assemblage 3 présentant une face 30 sensiblement plane. Il est ainsi possible, malgré le fait que plusieurs puces 2 soient d'épaisseurs sensiblement différentes entre elles, de mettre en oeuvre efficacement le procédé 100 selon l'invention en formant, sur un même substrat d'auto-alignement, des protubérances ayant toutes la même épaisseur ; de telles protubérances étant plus aisées à former. Toutefois, comme introduit précédemment, des protubérances de différents dimensionnements en épaisseur et/ou transversalement peuvent également être formées notamment pour adapter les dimensions en épaisseur et/ou transversales des puces destinées à y être auto-alignées. Une adaptation des dimensions des puces 2 et des protubérances 11 selon cette seconde variante représente un coût supplémentaire qui peut être contrebalancé par la potentielle réutilisation du substrat d'auto-alignement pour permettre l'auto-alignement d'autres pluralités de puces 2 et leur report sur d'éventuels autres substrats d'auto-assemblage.

Quelle que soit la variante choisie, ce choix étant potentiellement lié aux puces 2 (à leur nature, leurs dimensions, ou leur fonction), et donc aux composants microélectroniques, à auto-assembler 100, le procédé vise notamment à permettre que les puces 2 une fois auto-alignées sur le substrat d'auto-alignement 1 présentent des faces avant 22 hydrophiles qui s'inscrivent sensiblement dans un même plan. De la sorte, il sera possible de reporter 1051 simultanément, par leurs faces avant 22, toutes les puces 2 auto-alignées sur une face 30 avantageusement plane du substrat d'auto-assemblage 3, comme représenté sur les figures 3 et 7.

Le procédé selon l'invention dissocie avantageusement l'alignement et l'assemblage des puces 2, 6. L'alignement est réalisé lors d'une étape antérieure selon une approche du type 'puce à plaque' et l'assemblage est réalisé lors d'une étape ultérieure selon une approche du type 'plaque à plaque'. Un haut rendement qualitatif est ainsi potentiellement obtenu, puisque les puces 2, 6 peuvent être testées individuellement préalablement à leur auto-alignement.

Par rapport à la méthode d'auto-assemblage par effet capillaire décrite dans le document de brevet FR 2 988 517 A1, le procédé permet l'auto-assemblage de puces sur un substrat ne présentant pas nécessairement de protubérances sur le substrat final d'assemblage, et pallie ainsi le problème lié à l'intégration des protubérances sur de tels substrats. Pour autant, le procédé autorise l'obtention de l'auto-alignement des puces 2, 6 sur un substrat par effet capillaire. Le procédé selon l'invention permet ainsi d'obtenir l'assemblage simultané de nombreuses puces 2, 6 sur un substrat, le cas échéant fonctionnalisé, et autorise l'utilisation d'une méthode d'auto-alignement précise et prometteuse en vue d'une industrialisation des procédés de fabrication de circuits intégrés en trois dimensions.

Par rapport à la divulgation du document US 2012/021563, l'avantage technique majeur atteint ici est de pouvoir obtenir un meilleur alignement entre la puce et le substrat, tout en permettant un démontage subséquent facile. Il est proposé ici de s'assurer que l'énergie de collage direct entre chaque puce et le substrat d'auto-alignement est inférieure à l'énergie de collage direct entre chaque puce et le substrat d'auto-assemblage, en imposant au moins que la deuxième face 22 de chaque puce 2 soit hydrophile. Cette fonctionnalisation de la deuxième face 22 de chaque puce 2 est relativement aisée à mettre en oeuvre, et ce, de façon pleinement maîtrisée. Il est en outre encore possible, bien que non nécessaire, de jouer sur la rugosité de la deuxième face 22 de chaque puce 2, pour faire varier l'énergie de collage direct entre chaque puce et le substrat d'auto-assemblage.

L'invention n'est pas limitée aux modes de réalisations précédemment décrits et s'étend à tous les modes de réalisation couverts par les revendications.

Par exemple, la goutte 4 peut être déposée sur chaque puce 2, et plus particulièrement sur la première face 20 de chaque puce 2, plutôt que sur chaque protubérance 11 du substrat d'auto-alignement 1.

Par exemple, le substrat d'auto-alignement 1 peut être une plaque type 'chuck' électrostatique pour renforcer le collage des puces 2 auto-alignées sur les protubérances 11 et pouvoir relâcher ce renforcement de collage pour obtenir 105 l'auto-assemblage des puces 2 sur le substrat d'auto-assemblage 3. En effet, grâce à ce type de plaque, une fois alignées les puces 2 peuvent être maintenues par une charge au décollement, cette charge peut être annulée et les puces 2 peuvent être relâchées. De la même façon, on pourrait avoir recours à un chuck d'aspiration sous vide. On prévoira dans ce cas que le substrat d'auto-alignement dispose, au niveau des protubérances 11, de trous traversants permettant l'aspiration des puces 2 sur les protubérances 11.

Le substrat d'auto-alignement 1 et le substrat d'auto-assemblage 3 sont décrits dans les exemples ci-dessus comme étant à base de silicium, mais d'autres matériaux sont envisageables tels que du verre, du carbure de silicium (SiC), de l'arséniure de gallium (GaAs), etc.

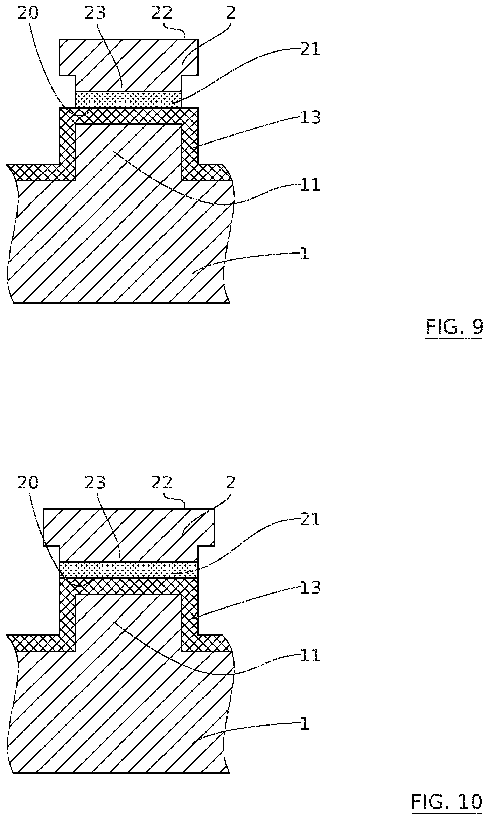

En référence aux figures 9 et 10, deux variantes du procédé 100 selon un mode de réalisation de l'invention sont discutées ci-dessous.

Selon chacune de ces deux variantes, la puce 2 présente, comme déjà évoqué plus haut, une première face 20 en protubérance 23. Ainsi, la surface de la deuxième face 22 de la puce 2 est sensiblement supérieure à la surface de la protubérance 23 de sa première face 20.

Dans l'exemple illustré sur la figure 9, la surface de la protubérance 23 de la première face 20 est sensiblement inférieure à la surface de la protubérance 11 du substrat d'auto-alignement 1. Dans l'exemple illustré sur la figure 10, la surface de la protubérance 23 de la première face 20 est sensiblement égale à la surface de la protubérance 11 du substrat d'auto-alignement 1. Néanmoins, dans les deux variantes illustrées, il peut être considéré que la protubérance 23 de la première face 20 et la deuxième face 22 sont sensiblement de mêmes dimensions que la face supérieure 111 de la protubérance 11. Par exemple, la surface de la protubérance 23 est comprise entre 60 et 99 %, de préférence entre 85 et 95 %, de la surface de la deuxième face 22 de la puce 2. Ainsi, l'effet capillaire permettant d'obtenir 104 l'auto-alignement de la puce 2 sur la protubérance 11 peut être considéré observé quelle que soit la variante adoptée parmi les variantes illustrées sur les figures 9 et 10. La première face 20 en protubérance 23 améliore avantageusement l'auto-alignement obtenu 104.

## Revendications

1. Procédé d'auto-assemblage (100) de composants microélectroniques comprenant les étapes suivantes:
- Fournir (101) un substrat dit d'auto-alignement (1) comprenant une pluralité de protubérances (11) présentant chacune une épaisseur supérieure à 1 µm et présentant chacune une face supérieure (111) et des flancs (112), la face supérieure (111) et les flancs (112) étant hydrophobes,
- Fournir (102) une pluralité de puces (2), chaque puce présentant une première face (20) et une deuxième face (22) hydrophile,
- Fournir (103) un substrat dit d'auto-assemblage (3),
- Obtenir (104), par effet capillaire, l'auto-alignement de chaque puce (2), par sa première face (20), sur une unique protubérance (11) du substrat d'auto-alignement (1) sous l'effet des forces de rappel d'une goutte (4) d'un liquide interposée entre chaque puce (1) et la protubérance (11) correspondante, puis
- Obtenir (105) l'assemblage de la pluralité de puces (2) sur le substrat d'auto-assemblage (3), par collage direct sur le substrat d'auto-assemblage (3) de la deuxième face (22) hydrophile de chaque puce (2).

2. Procédé (100) selon la revendication précédente, dans lequel le substrat d'auto-assemblage (3) présente une pluralité de zones de réception hydrophiles et dans lequel obtenir (105) l'assemblage de la pluralité de puces (2) sur le substrat d'auto-assemblage (3) comprend au moins l'alignement du substrat d'auto-alignement (1) et du substrat d'auto-assemblage (3), de sorte que chaque puce (2) soit située en vis-à-vis d'une zone de réception hydrophile du substrat d'auto-assemblage (3) et soit reportée par collage direct sur la zone de réception hydrophile située en vis-à-vis.

3. Procédé (100) selon l'une des revendications précédentes, dans lequel l'au moins une puce (2) présente une première face (20) en protubérance (23).

4. Procédé (100) selon l'une quelconque des revendications précédentes, dans lequel, le substrat d'auto-alignement (1) comportant une face avant (10) structurée par ladite au moins une protubérance (11), fournir (101) le substrat d'auto-alignement (1) comprend l'étape suivante : traiter (1011) la face avant (10) du substrat d'auto-alignement (1) pour rendre hydrophobe, voire superhydrophobe :
- au moins la face supérieure (111) et les flancs (112) de ladite au moins une protubérance (11), et
- potentiellement toute la face avant (10) du substrat d'auto-alignement (1).

5. Procédé (100) selon la revendication précédente, dans lequel traiter (1011) la face avant (10) du substrat d'auto-alignement (1) comprend au moins l'une parmi les étapes suivantes :
- ladite au moins une protubérance étant à base de silicium, traiter au moins sa face supérieure (111) et ses flancs (112) avec de l'acide fluorhydrique, en solution aqueuse, par exemple à une concentration de 1 % en acide fluorhydrique, ou sous forme vapeur,
- déposer une couche d'un polymère fluoré, de préférence fluorocarboné, au moins sur la face supérieure (111) et les flancs (112) de ladite au moins une protubérance (11), par exemple par exposition à un plasma formé à partir d'octafluorobutène, d'héxafluoroéthane, de tétrafluorure de carbone 20 et/ou de trifluorométhane,
- déposer une couche de polydiméthylsiloxane, PDMS, au moins sur la face supérieure (111) et les flancs de ladite au moins une protubérance (11), et
- déposer une couche de SiOC au moins sur la face supérieure (111) et les flancs (112) de ladite au moins une protubérance (11), par exemple par dépôt chimique en phase vapeur assisté par plasma en utilisant un gaz comprenant du silicium, un gaz contenant de l'oxygène et un gaz comprenant du carbone.

6. Procédé (100) selon la revendication 4, dans lequel, lorsque le substrat d'auto-alignement (1) est à base de silicium (Si), traiter (1011) la face avant (10) du substrat d'auto-alignement (1) comprend au moins l'une parmi les étapes suivantes :
- graver le substrat d'auto-alignement (1) par plasma de manière à obtenir du silicium noir au moins sur la face supérieure (111) et les flancs (112) de ladite au moins une protubérance (11), et
- déposer une couche d'un polymère fluoré, de préférence fluorocarboné, au moins sur la face supérieure (111) et les flancs (112) de ladite au moins une protubérance (11), par exemple par exposition à un plasma formé à partir d'octafluorobutène, d'héxafluoroéthane, de tétrafluorure de carbone 20 et/ou de trifluorométhane.

7. Procédé (100) selon l'une quelconque des revendications précédentes, dans lequel obtenir (104) l'auto-alignement de ladite au moins une puce (2) sur l'au moins une protubérance (11) du substrat d'auto-alignement (1) comprend au moins les étapes successives suivantes :
- Déposer (1041) une goutte (4) d'un liquide comprenant de l'eau sur l'une parmi la face supérieure (111) de la protubérance (11) et une première face (20) de la puce (2), la goutte (4) ayant de préférence un volume compris entre 0,5 et 2 µL, encore plus préférentiellement comprise entre 0,8 et 1,2 µL,
- Amener (1042) la puce (2) sur la protubérance (11) de sorte à ce que la goutte (4) soit disposée entre la puce (2) et la protubérance (11) et obtenir ainsi l'auto-alignement de la puce (2) sur la protubérance (11) par effet capillaire, et
- Faire évaporer (1043) la goutte (4) de sorte à obtenir le collage direct de la puce (2), par sa première face (20), sur la face supérieure (111) de la protubérance (11).

8. Procédé (100) selon la revendication précédente, dans lequel obtenir (104) l'auto-alignement de ladite au moins une puce (2) sur l'au moins une protubérance (11) du substrat d'auto-alignement (1) comprend, lorsqu'une puce (2) est non alignée suite à l'évaporation (1043) de la goutte (4), au moins les étapes successives suivantes :
- Eloigner la puce (2) non alignée depuis la protubérance,
- Nettoyer au moins l'une parmi la face supérieure (111) de ladite protubérance (11) depuis laquelle la puce (2) a été éloignée et la première face (20) de la puce (2), et
- Ramener la puce (2), par sa première face (20), sur ladite protubérance (11), de sorte à obtenir l'alignement et le collage direct de la puce (2) sur ladite protubérance (11).

9. Procédé (100) selon l'une quelconque des revendications précédentes, dans lequel, au moins lorsque plusieurs puces (2) sont d'épaisseurs sensiblement différentes entre elles, fournir (101) le substrat d'auto-alignement (1) comprend l'étape suivante : déposer une couche (12) d'un polymère compressible, par exemple une couche de polydiméthylsiloxane, au moins sous une des protubérances (11), de sorte à pouvoir absorber par compression les différences d'épaisseur entre puces (2).

10. Procédé (100) selon l'une quelconque des revendications précédentes, dans lequel fournir (102) ladite au moins une puce (2) comprend au moins l'étape suivante : traiter ladite au moins une puce (2) de manière à la fonctionnaliser.

11. Procédé (100) selon l'une quelconque des revendications précédentes, dans lequel fournir (102) ladite au moins une puce (2) comprend en outre l'étape suivante :
- préparer la puce (2) de sorte que sa première face (20) soit hydrophobe, et présente par exemple un angle de contact supérieur ou égal à 20°, la première face (20) étant celle par laquelle la puce (2) est destinée à être auto-alignée sur l'au moins une protubérance (11).

12. Procédé (100) selon l'une quelconque des revendications précédentes, dans lequel les étapes consistant à fournir (101) le substrat d'auto-alignement (1) et à fournir (102) ladite au moins une puce (2) sont réalisées de sorte que la face supérieure (111) de chaque protubérance (11) et la puce (2) destinée à être auto-alignée sur cette protubérance (11) soient de mêmes dimensions.

13. Procédé (100) selon l'une quelconque des revendications précédentes, dans lequel fournir (103) un substrat d'auto-assemblage (3) comprend des étapes technologiques de manière à le fonctionnaliser, ces étapes technologiques comprenant par exemple au moins l'une parmi les étapes suivantes :
- générer une couche d'un matériau diélectrique sur une partie d'une face (30) du substrat d'auto-assemblage (3) sur laquelle ladite au moins une puce (2) est destinée à être assemblée, par oxydation de surface et/ou dépôt,
- générer une couche d'un matériau conducteur sur une partie de la face (30) du substrat d'auto-assemblage (3) sur laquelle ladite au moins une puce (2) est destinée à être assemblée, et
- générer des trous d'interconnexion dans une partie au moins de l'épaisseur du substrat d'auto-assemblage (3).

14. Procédé (100) selon l'une quelconque des revendications précédentes, dans lequel obtenir (105) l'assemblage de ladite au moins une puce (2) sur le substrat d'auto-assemblage (3) comprend au moins les étapes successives suivantes :
- Reporter (1051), par une (30) de ses faces, le substrat d'auto-assemblage (3) sur la deuxième face (22) hydrophile de chaque puce (2), le cas échéant ce report (1051) étant réalisé en utilisant un équipement d'alignement dit 'plaque à plaque',
- Coller (1052), par collage direct, le substrat d'auto-assemblage (3) sur la deuxième face (22) hydrophile de chaque puce (2) et recuire l'ensemble, de sorte que l'énergie de collage entre chaque puce (2) et le substrat d'auto-assemblage (3) soit supérieure à l'énergie de collage entre chaque puce (2) et le substrat d'auto-alignement (1), et
- Séparer (1053) les substrats d'auto-alignement (1) et d'auto-assemblage (2) entre eux de sorte à décoller chaque puce (2) depuis le substrat d'auto-alignement (1) et obtenir le report de chaque puce (2) sur le substrat d'auto-assemblage (3).

15. Procédé (100) selon l'une quelconque des revendications précédentes, comprenant en outre, après avoir obtenu (105) l'assemblage d'au moins une première puce (2) sur le substrat d'auto-assemblage (3), au moins les étapes suivantes :
- Fournir un second substrat d'auto-alignement (5) comprenant au moins une protubérance (51) présentant une épaisseur supérieure à 1 µm et une face supérieure (511) et des flancs hydrophobes, ladite au moins une protubérance (51) du second substrat d'auto-alignement (5) ayant le cas échéant une épaisseur supérieure à l'épaisseur de ladite au moins une protubérance (11) du substrat d'auto-alignement (1) préalablement fourni (101),
- Fournir au moins une seconde puce (6) présentant une première face et une deuxième face opposée entre elles et ayant potentiellement une épaisseur significativement différente de l'épaisseur de ladite au moins une puce (2) préalablement fournie (102), la deuxième face de ladite au moins une seconde puce (6) étant hydrophile,
- Obtenir, par effet capillaire, l'auto-alignement de ladite au moins une seconde puce (6), par sa première face, sur l'au moins une protubérance (51) du second substrat d'auto-alignement (5), puis
- Obtenir l'assemblage de ladite au moins une seconde puce (6) sur le substrat d'auto-assemblage (3), par exemple en un emplacement du substrat d'auto-assemblage (3) différent de l'emplacement de ladite au moins une première puce (2), par collage direct sur le substrat d'auto-assemblage (3) de ladite au moins une seconde puce (6).

## Patentansprüche

1. Verfahren zur Selbstmontage (100) mikroelektronischer Komponenten, umfassend die folgenden Schritte:
- Bereitstellen (101) eines selbstausrichtenden Substrats (1), das eine Vielzahl von Vorsprüngen (11) umfasst, von denen jeder eine Dicke von mehr als 1 µm aufweist und jeweils eine obere Fläche (111) und Flanken (112) aufweist, wobei die obere Fläche (111) und die Flanken (112) hydrophob sind,
- Bereitstellen (102) einer Vielzahl von Dies (2), wobei jeder Die eine erste Fläche (20) und eine zweite hydrophile Fläche (22) aufweist,
- Bereitstellen (103) eines selbstmontierenden Substrats (3),
- Erhalten (104), durch Kapillarwirkung, der Selbstausrichtung jedes Dies (2) durch dessen erste Fläche (20) auf einem einzelnen Vorsprung (11) des selbstausrichtenden Substrats (1) unter der Wirkung der Rückstellkräfte eines Tropfens (4) einer Flüssigkeit, die zwischen jedem Die (1) und dem entsprechenden Vorsprung (11) eingefügt ist, anschließend
- Erhalten (105) der Montage der Vielzahl von Dies (2) auf dem selbstmontierenden Substrat (3) durch eine direkte Klebeverbindung der zweiten hydrophilen Fläche (22) jedes Dies (2) auf dem selbstmontierenden Substrat (3).

2. Verfahren (100) nach dem vorhergehenden Anspruch, wobei das selbstmontierende Substrat (3) eine Vielzahl von hydrophilen Aufnahmezonen aufweist und wobei das Erhalten (105) der Montage der Vielzahl von Dies (2) auf dem selbstmontierenden Substrat (3) mindestens die Ausrichtung des selbstausrichtenden Substrats (1) und des selbstmontierenden Substrats (3) umfasst, so dass sich jeder Die (2) gegenüber einer hydrophilen Aufnahmezone des selbstmontierenden Substrats (3) befindet und durch eine direkte Klebeverbindung auf die gegenüberliegende hydrophile Aufnahmezone übertragen wird.

3. Verfahren (100) nach einem der vorhergehenden Ansprüche, wobei der mindestens eine Die (2) eine erste Fläche (20) in Vorsprung (23) aufweist.

4. Verfahren (100) nach einem der vorhergehenden Ansprüche, wobei das selbstausrichtende Substrat (1) eine vordere Fläche (10) umfasst, die durch den mindestens einen Vorsprung (11) strukturiert ist, wobei das Bereitstellen (101) des selbstausrichtenden Substrats (1) den folgenden Schritt umfasst: Behandeln (1011) der vorderen Fläche (10) des selbstausrichtenden Substrats (1), um Folgendes hydrophob bzw. superhydrophob zu machen:
- mindestens die obere Fläche (111) und die Flanken (112) des mindestens einen Vorsprungs (11), und
- möglicherweise die gesamte vordere Fläche (10) des selbstausrichtenden Substrats (1).

5. Verfahren (100) nach dem vorhergehenden Anspruch, wobei das Behandeln (1011) der vorderen Fläche (10) des selbstausrichtenden Substrats (1) mindestens einen der folgenden Schritte umfasst:
- wobei der mindestens eine Vorsprung auf Silizium basiert, Behandeln mindestens seiner oberen Fläche (111) und seiner Flanken (112) mit Flusssäure in einer wässrigen Lösung, zum Beispiel mit einer Konzentration von 1 % Flusssäure, oder in dampfförmiger Form,
- Abscheiden einer Schicht aus einem Fluorpolymer, vorzugsweise Fluorkohlenstoffpolymer, mindestens auf der oberen Fläche (111) und den Flanken (112) des mindestens einen Vorsprungs (11), zum Beispiel durch Einwirkung eines Plasmas, das aus Octafluorbuten, Hexafluorethan, Kohlenstofftetrafluorid 20 und/oder Trifluormethan gebildet wird,
- Abscheiden einer Polydimethylsiloxanschicht, PDMS-Schicht, mindestens auf der oberen Fläche (111) und den Flanken des mindestens einen Vorsprungs (11), und
- Abscheiden einer SiOC-Schicht mindestens auf der oberen Fläche (111) und den Flanken (112) des mindestens einen Vorsprungs (11), zum Beispiel durch plasmaunterstützte chemische Gasphasenabscheidung unter Verwendung eines Silizium umfassenden Gases, eines Sauerstoff enthaltenden Gases und eines Kohlenstoff umfassenden Gases.

6. Verfahren (100) nach Anspruch 4, wobei, wenn das selbstausrichtende Substrat (1) auf Silizium (Si) basiert, das Behandeln (1011) der vorderen Fläche (10) des selbstausrichtenden Substrats (1) mindestens einen der folgenden Schritte umfasst:
- Ätzen des selbstausrichtenden Substrats (1) durch Plasma, um schwarzes Silizium mindestens auf der oberen Fläche (111) und den Flanken (112) des mindestens einen Vorsprungs (11) zu erhalten, und
- Abscheiden einer Schicht aus einem Fluorpolymer, vorzugweise Fluorkohlenstoffpolymer, mindestens auf der oberen Fläche (111) und den Flanken (112) des mindestens einen Vorsprungs (11), zum Beispiel durch Einwirkung eines Plasmas, das aus Octafluorbuten, Hexafluorethan, Kohlenstofftetrafluorid 20 und/oder Trifluormethan gebildet wird.

7. Verfahren (100) nach einem der vorhergehenden Ansprüche, wobei das Erhalten (104) der Selbstausrichtung des mindestens einen Dies (2) auf dem mindestens einen Vorsprung (11) des selbstausrichtenden Substrats (1) mindestens die folgenden aufeinanderfolgenden Schritte umfasst:
- Abscheiden (1041) eines Tropfens (4) einer wasserhaltigen Flüssigkeit auf die obere Fläche (111) des Vorsprungs (11) oder eine erste Fläche (20) des Dies (2), wobei der Tropfen (4) vorzugsweise ein Volumen zwischen 0,5 und 2 µl, noch bevorzugter zwischen 0,8 und 1,2 µl aufweist,
- Zuführen (1042) des Dies (2) auf den Vorsprung (11), so dass der Tropfen (4) zwischen dem Die (2) und dem Vorsprung (11) angeordnet wird und so die Selbstausrichtung des Dies (2) auf dem Vorsprung (11) durch Kapillarwirkung erreicht wird, und
- Verdampfenlassen (1043) des Tropfens (4), um eine direkte Klebeverbindung des Dies (2) über seine erste Fläche (20) auf der oberen Fläche (111) des Vorsprungs (11) zu erhalten.

8. Verfahren (100) nach dem vorhergehenden Anspruch, wobei das Erhalten (104) der Selbstausrichtung des mindestens einen Dies (2) auf dem mindestens einen Vorsprung (11) des selbstausrichtenden Substrats (1), wenn ein Die (2) nach der Verdampfung (1043) des Tropfens (4) nicht ausgerichtet ist, mindestens die folgenden aufeinanderfolgenden Schritte umfasst:
- Bewegen des nicht ausgerichteten Dies (2) vom Vorsprung weg,
- Reinigen mindestens einer der oberen Flächen (111) des Vorsprungs (11), von der der Die (2) wegbewegt wurde, und der ersten Fläche (20) des Dies (2), und
- Zurückbringen des Dies (2) durch seine erste Fläche (20) auf den Vorsprung (11), um so die Ausrichtung und die direkte Klebeverbindung des Dies (2) auf dem Vorsprung (11) zu erhalten.

9. Verfahren (100) nach einem der vorhergehenden Ansprüche, wobei, zumindest wenn mehrere Dies (2) eine im Wesentlichen unterschiedliche Dicke aufweisen, das Bereitstellen (101) des selbstausrichtenden Substrats (1) den folgenden Schritt umfasst: Abscheiden einer Schicht (12) aus einem komprimierbaren Polymer, zum Beispiel einer Polydimethylsiloxanschicht, mindestens unter einem der Vorsprünge (11), um so die Dickenunterschiede zwischen den Dies (2) durch Kompression ausgleichen zu können.

10. Verfahren (100) nach einem der vorhergehenden Ansprüche, wobei das Bereitstellen (102) des mindestens einen Dies (2) mindestens den folgenden Schritt umfasst: Behandeln des mindestens einen Dies (2), um ihn zu funktionalisieren.

11. Verfahren (100) nach einem der vorhergehenden Ansprüche, wobei das Bereitstellen (102) des mindestens einen Dies (2) ferner den folgenden Schritt umfasst:
- Vorbereiten des Dies (2), so dass seine erste Fläche (20) hydrophob ist und zum Beispiel einen Kontaktwinkel von größer gleich 20° aufweist, wobei die erste Fläche (20) diejenige ist, mit der der Die (2) auf dem mindestens einen Vorsprung (11) selbstausgerichtet werden soll.

12. Verfahren (100) nach einem der vorhergehenden Ansprüche, wobei die Schritte, die aus dem Bereitstellen (101) des selbstausrichtenden Substrats (1) und das Bereitstellen (102) des mindestens einen Dies (2) bestehen, so durchgeführt werden, dass die obere Fläche (111) jedes Vorsprungs (11) und der Die (2), der auf diesem Vorsprung (11) selbstausgerichtet werden soll, die gleichen Abmessungen haben.

13. Verfahren (100) nach einem der vorhergehenden Ansprüche, wobei das Bereitstellen (103) eines selbstmontierenden Substrats (3) technologische Schritte umfasst, um dieses zu funktionalisieren, wobei die technologischen Schritte mindestens einen der folgenden Schritte umfassen:
- Erzeugen einer Schicht aus einem dielektrischen Material auf einem Teil einer Fläche (30) des selbstmontierenden Substrats (3), auf dem der mindestens eine Die (2) montiert werden soll, durch Oberflächenoxidation und/oder Abscheidung,
- Erzeugen einer Schicht aus einem leitenden Material auf einem Teil der Fläche (30) des selbstmontierenden Substrats (3), auf dem der mindestens eine Die (2) montiert werden soll, und
- Erzeugen von Durchkontaktierungen in einem Teil von mindestens der Dicke des selbstmontierenden Substrats (3).

14. Verfahren (100) nach einem der vorhergehenden Ansprüche, wobei das Erhalten (105) der Montage des mindestens einen Dies (2) auf dem selbstmontierenden Substrat (3) mindestens die folgenden aufeinanderfolgenden Schritte umfasst:
- Übertragen (1051) des selbstmontierenden Substrats (3) auf die zweite hydrophile Fläche (22) jedes Dies (2) durch eine (30) seiner Flächen, wobei dieses Übertragen (1051) gegebenenfalls unter Verwendung einer sogenannten "Wafer-zu-Wafer"-Ausrichtungsausrüstung durchgeführt wird,
- Ankleben (1052) des selbstmontierenden Substrats (3) durch direkte Klebeverbindung auf die zweite hydrophile Fläche (22) jedes Dies (2) und Aushärten der Anordnung, so dass die Klebeverbindungsenergie zwischen jedem Die (2) und dem selbstmontierenden Substrat (3) größer ist als die Klebeverbindungsenergie zwischen jedem Die (2) und dem selbstausrichtenden Substrats (1), und
- Trennen (1053) der selbstausrichtenden (1) und selbstmontierenden (2) Substrate voneinander, um jeden Die (2) vom selbstausrichtenden Substrat (1) zu lösen und die Übertragung jedes Dies (2) auf das selbstmontierende Substrat (3) zu erhalten.

15. Verfahren (100) nach einem der vorhergehenden Ansprüche, ferner umfassend, nachdem die Montage mindestens eines ersten Dies (2) auf dem selbstmontierenden Substrat (3) erhalten (105) wurde, mindestens die folgenden Schritte:
- Bereitstellen eines zweiten selbstausrichtenden Substrats (5), das mindestens einen Vorsprung (51) mit einer Dicke von mehr als 1 µm und eine obere Fläche (511) und hydrophobe Flanken umfasst, wobei der mindestens eine Vorsprung (51) des zweiten selbstausrichtenden Substrats (5) gegebenenfalls eine Dicke aufweist, die größer ist als die Dicke des mindestens einen Vorsprungs (11) des zuvor bereitgestellten (101) selbstausrichtenden Substrats (1),
- Bereitstellen mindestens eines zweiten Dies (6) mit einer ersten Fläche und einer zweiten Fläche, die einander gegenüberliegen und möglicherweise eine Dicke aufweisen, die sich deutlich von der Dicke des mindestens einen zuvor bereitgestellten (102) Dies (2) unterscheidet, wobei die zweite Fläche des mindestens einen zweiten Dies (6) hydrophil ist,
- Erhalten der Selbstausrichtung des mindestens einen zweiten Dies (6) durch dessen erste Fläche auf dem mindestens einen Vorsprung (51) des zweiten selbstausrichtenden Substrats (5) durch Kapillarwirkung, anschließend
- Erhalten der Montage des mindestens einen zweiten Dies (6) auf dem selbstmontierenden Substrat (3), zum Beispiel in einer Platzierung des selbstmontierenden Substrats (3), die sich von der Platzierung des mindestens einen ersten Dies (2) unterscheidet, durch direkte Klebeverbindung auf dem selbstmontierenden Substrat (3) des mindestens einen zweiten Dies (6).

## Claims

1. A self-assembly method (100) for microelectronic components comprising the following steps:
- Providing (101) a so-called self-alignment substrate (1) comprising a plurality of protrusions (11) each having a thickness greater than 1 µm and each having an upper face (111) and sides (112), the upper face (111) and sides (112) being hydrophobic,
- Providing (102) a plurality of chips (2), each chip having a first face (20) and a second hydrophilic face (22),
- Providing (103) a so-called self-assembly substrate (3),
- Obtaining (104), by capillary effect, the self alignment of each chip (2), by its first face (20), on a single protrusion (11) of the self-alignment substrate (1) under the effect of the return forces of a drop (4) of a liquid interposed between each chip (1) and the corresponding protrusion (11), then
- Obtaining (105) the assembly of the plurality of chips (2) on the self-assembly substrate (3), by direct gluing on the self-assembly substrate (3) of the second hydrophilic face (22) of each chip (2).

2. The method (100) according to the preceding claim, wherein the self-assembly substrate (3) has a plurality of hydrophilic reception areas and wherein obtaining (105) the assembly of the plurality of chips (2) on the self-assembly substrate (3) comprises at least aligning the self-alignment substrate (1) and the self-assembly substrate (3), such that each chip (2) is located opposite a hydrophilic reception area of the self-assembly substrate (3) and is transferred by direct gluing to the hydrophilic reception area located opposite thereto.

3. The method (100) according to one of the preceding claims, wherein the at least one chip (2) has a first face (20) in protrusion (23).

4. The method (100) according to any one of the preceding claims, wherein, the self-alignment substrate (1) including a front face (10) structured by said at least one protrusion (11), providing (101) the self-alignment substrate (1) comprises the following step: treating (1011) the front face (10) of the self-alignment substrate (1) to make it hydrophobic, or even superhydrophobic:
- at least the upper face (111) and the sides (112) of said at least one protrusion (11), and
- potentially the entire front face (10) of the self-alignment substrate (1).

5. The method (100) according to the preceding claim, wherein treating (1011) the front face (10) of the self-alignment substrate (1) comprises at least one of the following steps:
- said at least one protrusion being based on silicon, treating at least its upper face (111) and its sides (112) with hydrofluoric acid, in aqueous solution, for example at a concentration of 1% hydrofluoric acid, or in vapour form,
- depositing a layer of a fluoropolymer, preferably fluorocarbon, at least on the upper face (111) and the sides (112) of said at least one protrusion (11), for example by exposure to a plasma formed from octafluorobutene, hexafluoroethane, carbon tetrafluoride 20 and/or trifluoromethane,
- depositing a layer of polydimethylsiloxane, PDMS, at least on the upper face (111) and the sides of said at least one protrusion (11), and
- depositing a layer of SiOC at least on the upper face (111) and the sides (112) of said at least one protrusion (11), for example by plasma enhanced chemical vapour deposition using a gas comprising silicon, a gas containing oxygen and a gas comprising carbon.

6. The method (100) according to claim 4, wherein, when the self-alignment substrate (1) is based on silicon (Si), treating (1011) the front face (10) of the self-alignment substrate (1) comprises at least one of the following steps:
- etching the self-alignment substrate (1) by plasma so as to obtain black silicon at least on the upper face (111) and the sides (112) of said at least one protrusion (11), and
- depositing a layer of a fluoropolymer, preferably fluorocarbon, at least on the upper face (111) and the sides (112) of said at least one protrusion (11), for example by exposure to a plasma formed from octafluorobutene, hexafluoroethane, carbon tetrafluoride 20 and/or trifluoromethane.

7. The method (100) according to any one of the preceding claims, wherein obtaining (104) the self-alignment of said at least one chip (2) on the at least one protrusion (11) of the self-alignment substrate (1) comprises at least the following successive steps:
- Depositing (1041) a drop (4) of a liquid comprising water on one of the upper face (111) of the protrusion (11) and a first face (20) of the chip (2), the drop (4) preferably having a volume comprised between 0.5 and 2 µL, even more preferably between 0.8 and 1.2 µL,
- Bringing (1042) the chip (2) onto the protrusion (11) so that the drop (4) is disposed between the chip (2) and the protrusion (11) and thus obtaining the self-alignment of the chip (2) on the protrusion (11) by capillary effect, and
- Evaporating (1043) the drop (4) so as to obtain direct gluing of the chip (2), by its first face (20), on the upper face (111) of the protrusion (11).

8. The method (100) according to the preceding claim, wherein obtaining (104) the self alignment of said at least one chip (2) on the at least one protrusion (11) of the self-alignment substrate (1) comprises, when a chip (2) is unaligned following the evaporation (1043) of the drop (4), at least the following successive steps:
- Moving the unaligned chip (2) away from the protrusion,
- Cleaning at least one of the upper face (111) of said protrusion (11) from which the chip (2) has been moved away and the first face (20) of the chip (2), and
- Bringing the chip (2) back, by its first face (20), onto said protrusion (11), so as to obtain the alignment and direct gluing of the chip (2) on said protrusion (11).

9. The method (100) according to any one of the preceding claims, wherein, at least when several chips (2) are of thicknesses that are substantially different from each other, providing (101) the self-alignment substrate (1) comprises the following step: depositing a layer (12) of a compressible polymer, for example a layer of polydimethylsiloxane, at least under one of the protrusions (11), so as to be able to absorb by compression the differences in thickness between chips (2).

10. The method (100) according to any one of the preceding claims, wherein providing (102) said at least one chip (2) comprises at least the following step: treating said at least one chip (2) so as to functionalise it.

11. The method (100) according to any one of the preceding claims, wherein providing (102) said at least one chip (2) further comprises the following step:
- preparing the chip (2) so that its first face (20) is hydrophobic, and has for example a contact angle greater than or equal to 20°, the first face (20) being that by which the chip (2) is intended to be self-aligned with the at least one protrusion (11).

12. The method (100) according to any one of the preceding claims, wherein the steps consisting of providing (101) the self-alignment substrate (1) and providing (102) said at least one chip (2) are carried out so that the upper face (111) of each protrusion (11) and the chip (2) intended to be self-aligned on this protrusion (11) are of the same dimensions.

13. The method (100) according to any one of the preceding claims, wherein providing (103) a self-assembly substrate (3) comprises technological steps so as to functionalise it, these technological steps comprising for example at least one of the following steps:
- generating a layer of a dielectric material on a part of a face (30) of the self-assembly substrate (3) on which said at least one chip (2) is intended to be assembled, by surface oxidation and/or deposition,
- generating a layer of a conductive material on a part of the face (30) of the self-assembly substrate (3) on which said at least one chip (2) is intended to be assembled, and
- generating via holes in at least part of the thickness of the self-assembly substrate (3).

14. The method (100) according to any one of the preceding claims, wherein obtaining (105) the assembly of said at least one chip (2) on the self-assembly substrate (3) comprises at least the successive following steps:
- Transferring (1051), by one (30) of its faces, the self-assembly substrate (3) onto the second hydrophilic face (22) of each chip (2), where appropriate this transfer (1051) being carried out using 'plate to plate' alignment equipment,
- Gluing (1052), by direct gluing, the self-assembly substrate (3) on the second hydrophilic face (22) of each chip (2) and annealing the assembly, so that the gluing energy between each chip (2) and the self-assembly substrate (3) is greater than the gluing energy between each chip (2) and the self-alignment substrate (1), and
- Separating (1053) the self-alignment substrates (1) and self-assembly substrates (2) from each other so as to peel off each chip (2) from the self-alignment substrate (1) and obtain the transfer of each chip (2) onto the self-assembly substrate (3).

15. The method (100) according to any one of the preceding claims, further comprising, after having obtained (105) the assembly of at least one first chip (2) on the self-assembly substrate (3), at least the following steps:
- Providing a second self-alignment substrate (5) comprising at least one protrusion (51) having a thickness greater than 1 µm and an upper face (511) and hydrophobic sides, said at least one protrusion (51) of the second self-alignment substrate (5) having, where appropriate, a thickness greater than the thickness of said at least one protrusion (11) of the self-alignment substrate (1) previously provided (101),
- Providing at least one second chip (6) having a first face and a second face opposite each other and potentially having a thickness significantly different from the thickness of said at least one chip (2) previously provided (102), the second face of said at least one second chip (6) being hydrophilic,
- Obtaining, by capillary effect, the self-alignment of said at least one second chip (6), by its first face, on the at least one protrusion (51) of the second self-alignment substrate (5), then
- Obtaining the assembly of said at least one second chip (6) on the self-assembly substrate (3), for example at a location of the self-assembly substrate (3) different from the location of said at least one first chip (2), by direct gluing on the self-assembly substrate (3) of said at least one second chip (6).
